(19)

Europäisches Patentamt

European Patent Office

Office européen des brevets

(11) **EP 2 778 939 A2**

(12) **EUROPEAN PATENT APPLICATION**

(43) Date of publication:
**17.09.2014 Bulletin 2014/38**

(51) Int Cl.:
***G06F 13/40*** (2006.01)

(21) Application number: **14159593.4**

(22) Date of filing: **13.03.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **15.03.2013   US 201313844083**

(71) Applicant: **Intel Corporation
Santa Clara, CA 95054 (US)**

(72) Inventors:
• **Xu, Jianping**
  **Portland, Oregon 97229 (US)**
• **Faw, Donald**
  **Hillsboro Oregon 97124 (US)**
• **Iyer, Venkatraman**
  **Round Rock, Texas 78681 (US)**

(74) Representative: **Hufton, David Alan
HGF Limited
Fountain Precinct
Balm Green
Sheffield S1 2JA (GB)**

(54) **Optical memory extension architecture**

(57)    An optical memory extension architecture. A first electrical logic circuit on a first die communicates data according to a packetized, point-to-point interconnect protocol at a full data rate. A first gasket circuit is coupled to receive the data from the first electrical logic circuit. The first gasket circuit causes the data to be converted to an optical format to be transmitted at a rate that is at least double the full data rate. A second gasket circuit is coupled to receive the data in the optical format from the first gasket circuit. The second gasket circuit causes the data to be converted to an electrical format conforming to the packetized, point-to-point interconnect protocol. A second electrical logic circuit on a second die is coupled to receive the data from the first electrical logic circuit through the first gasket circuit and the second gasket circuit.

**FIG. 1**

EP 2 778 939 A2

**Description**

TECHNICAL FIELD

Embodiments of the invention relate to optical communications with memory systems in a host. More particularly, embodiments of the invention relate to techniques for proving optical communication between electronic devices (e.g., processing cores, memory devices, memory controllers) consistent with protocols used by the electronic devices.

BACKGROUND

As processing power increases and the number of processing cores that can be included on a single die increase, corresponding increases in memory bandwidth are necessary in order to maintain balanced system performance. Current architectures and techniques generally do not provide sufficient scalability to provide the corresponding increases in memory bandwidth.

BRIEF DESCRIPTION OF THE DRAWINGS

Embodiments of the invention are illustrated by way of example, and not by way of limitation, in the figures of the accompanying drawings in which like reference numerals refer to similar elements.

**Figure 1** is a block diagram of one embodiment of an optical interface.

**Figure 2** is a timing diagram of one embodiment of a gasket interface signal initialization process.

**Figure 3** is a flow diagram of one embodiment for Q2S gasket operation during the optical training pattern state.

**Figure 4** is a flow diagram of one embodiment for S2Q gasket operation during the optical training pattern state.

**Figure 5** is a block diagram of one embodiment of an optical memory extension (OME) system.

**Figure 6** is a top-level diagram of one embodiment of a Q2S module.

**Figure 7** is a block diagram of one embodiment of a Q2S analog front end (Q2SAFE).

**Figure 8** is a block diagram of one embodiment of a Q2S receiving analog front end (RxAFE).

**Figure 9a** is a circuit diagram of one embodiment of a RxAFE architecture for normal speed operation.

Figure 9b is a circuit diagram of one embodiment of a RxAFE architecture for high speed operation.

Figure 10 is a block diagram of one embodiment of a two-tap DFE/sampler circuit.

Figure 11 is an example half-rate sampling diagram.

Figure 12 is a circuit diagram of one embodiment of a complete Q2S data path and clock path architecture.

Figure 13 is a top-level diagram of one embodiment of a S2Q module.

Figure 14 is a block diagram of one embodiment of S2Q control logic (SCL).

Figure 15 is a block diagram of one embodiment of a S2Q analog front end.

**Figure 16** is a block diagram of one embodiment of a S2Q receive analog front end (RxAFE).

**Figure 17a** is a circuit diagram of one embodiment of a RxAFE architecture for normal speed operation.

**Figure 17b** is a circuit diagram of one embodiment of a RxAFE architecture for high speed operation.

**Figure 18** is an example quad-rate sampling diagram.

**Figure 19** is a block diagram of one embodiment of a S2Q transmit circuit architecture.

**Figure 20** is a circuit diagram of one embodiment of a complete S2Q data path and clock path architecture.

**Figure 21** illustrates embodiments of multi-processor configurations utilizing a high performance interconnect architecture.

**Figure 22** illustrates an embodiment of a layered stack for a high performance interconnect architecture.

<u>DETAILED DESCRIPTION</u>

In the following description, numerous specific details are set forth. However, embodiments of the invention may be practiced without these specific details. In other instances, well-known circuits, structures and techniques have not been shown in detail in order not to obscure the understanding of this description.

The architectures and techniques described herein provide an optical state machine and a training sequencer to enable optical memory extension. With technology scaling, modern embedded, server, and graphics processors already consist of tens to hundreds of cores on a single chip and the core number will continue to increase to even a thousand in 11 nm or 8 nm technology nodes. Corresponding increases in memory bandwidth and capacity are also required to increase for balanced system performance. These architectures and techniques target memory bandwidth with optical interconnects called optical memory extension.

In one embodiment, the described architectures and techniques can be used for incorporating Intel's Quick Path Interconnect (QPI) protocol with optical interconnects into mainstream servers, clients, system on chip (SoC), high-performance computers (HPC), and data center platforms. The Intel QuickPath Interconnect is a point-to-point processor interconnect developed by Intel that replaces the front-side bus (FSB) in certain platforms.

The QPI protocol is a high-speed, packetized, point-to-point interconnect protocol that allows narrow, high-speed links to stitch together processing cores and other nodes in a distributed shared memory-style platform architecture. The QPI protocol offers high bandwidth with low latency. The QPI protocol includes a snoop protocol optimized for low latency and high scalability as well as packet and lane structures enabling quick completions of transactions.

In one embodiment, the QPI protocol layer manages cache coherence for the interface using the write-back protocol. In one embodiment, it also has a set of rules for managing non-coherent messaging. The protocol layer typically connects to the cache coherence state machine in caching agents, and to the home agent logic in memory controllers. The protocol layer also is responsible for system level functions such as interrupts, memory mapped I/O, and locks. One major characteristic of the protocol layer is that it deals with messages across multiple links, involving multiple agents in multiple devices.

In one embodiment, the architectures and techniques described herein are used to extend QPI by optical means. In one embodiment, the state-machine and the sequencer described below operate to accommodate the QPI protocol with no awareness of the underlying optical link.

With technology scaling, modern embedded, server, and graphics processors already consist of tens to hundreds of cores on a single chip and the core number will continue to increase to even a thousand or more with 11 nm or 8 nm manufacturing processes. This architecture described herein operates to provide this memory bandwidth using optical interconnects called optical memory extension of QPI protocol.

In order to establish the optical domain of the link at full data rate on both clock and data lanes, an Optical Training Phase is needed. In one embodiment, this is followed by the QPI handshake phase where the remote and local gasket components establish a communication protocol on Data lane 0 and Data lane 5, for each half of the optical link. Messages are transferred across the optical link at full data rate. In one embodiment, the message frame is synchronized with the reference clock and only one message frame per reference clock period.

In one embodiment, the message includes a preamble, a command, data and a postamble. In one embodiment, the preamble is a 16-bit stream with a data pattern of FFFE, which marks the beginning of a message frame. Other patterns may also be used. In one embodiment, the command field is an 8-bit stream field to convey an action for the receiving interface to take. Each bit represents a command for a very simple decoding. Bit 7 can be used for extended commands if needed. In one embodiment, the data field is an 8-bit stream field containing data relevant to the command. In one embodiment, the postamble is a 4-bit stream repeating pattern of 1100 to fill the remainder of the data stream through the end of the reference clock period. The pattern is terminated with the last two bits in the stream as 0 so the preamble can be identified.

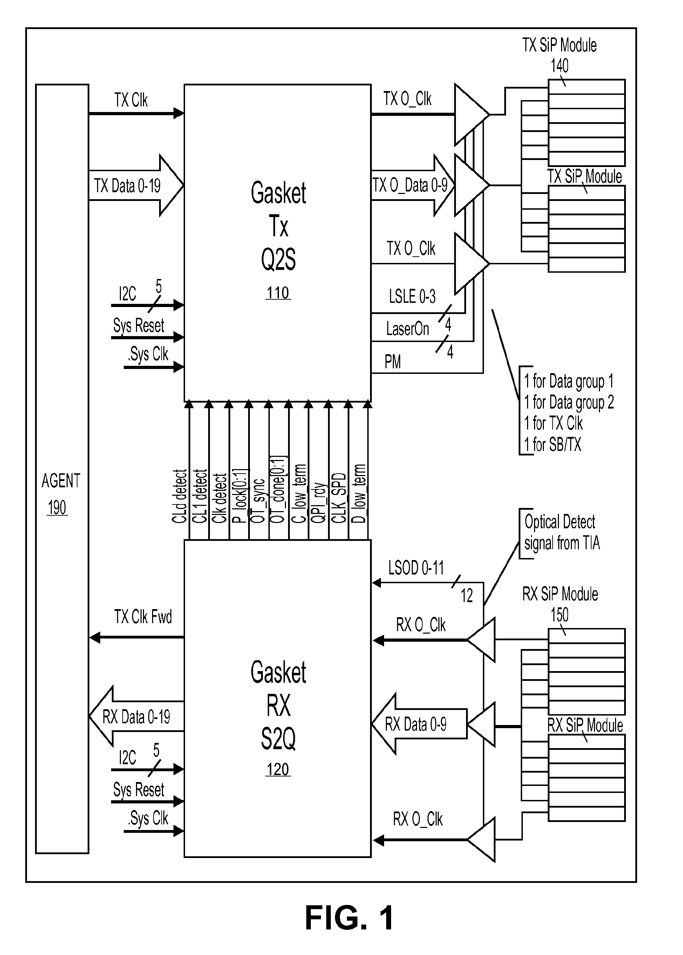

**Figure 1** is a block diagram of one embodiment of an optical interface. The major components of the interface are as follows: 1) Electrical (e.g., QPI) to optical (e.g., Silicon Photonics, SiP) Gasket transmission (Tx) Chip, (Q2S) 110;

2) Optical to electrical Gasket Receive (Rx) chip, (S2Q) 120; 3) Modulator Driver; 4) Transmit (TX) optical (SiP) Module 140; 5) Receive (RX) SiP Module 150; and 6) Transimpedance Amplifier (TIA).

In one embodiment, gasket components (110, 120) contain a 2:1 serializer/deserializer (SERDES) that multiplexes the electrical (e.g., 20 QPI) data lanes onto (e.g., 10) lanes that interface to the SiP module that does the electrical to optical conversion. In other embodiments, other ratios and other numbers of lanes can be supported. In one embodiment, the optical link is divided into two halves, the lower half caries the lower data lanes 0:9, and the upper half caries the upper data lanes 10:19. In other embodiments, other configurations can be supported.

Agent 190 is the electrical component that communicates with a remote component (e.g., memory), not illustrated in Figure 1. Agent 190 can be, for example, a processing core or other system component. In one embodiment, agent 190 provides a transmission (TX) clock signal as well as TX data (e.g., 0-19) to Q2S gasket chip 110. In some embodiments, agent 190 can also provide a system clock signal, a system reset signal and an I2C signal to Q2S gasket chip 110. In one embodiment, agent 190 receives, from S2Q gasket chip 120, a TX clock forward signal and receive (RX) data (e.g., 0-19). In some embodiments, agent 190 can also provide a system clock signal, a system reset signal and an I2C signal to S2Q gasket chip 120.

In one embodiment, Q2S gasket chip 110 and S2Q gasket chip 120 are coupled so that S2Q gasket chip 120 sends control signals to Q2S gasket chip 110. Output signals from Q2S gasket chip 110 include a TX clock signal (e.g., TX O_Clk), data signals (e.g., TX O_Data 0:9) and control signals to one or more transmit optical modules 140. Input signals to S2Q gasket chip 120 include a RX clock signal (e.g., RX O_Clk), data signals (e.g., RX O_Data 0:9) and control signals from one or more receive optical modules 150.

In order to establish the optical connectivity, the state machine described below with training sequence is utilized with the optical interface of Figure 1. In one embodiment, an inside-to-outside initialization sequence of the optical to electrical link, the optical domain connectivity is established first. This transparent optical link is then used for electrical (e.g., QPI) handshake and a link between the electrical agents is established. The optical domain has 4 major phases to the initialization sequence, listed in Table 1:

| Phase: | Optical Connect Phase | | | Optical Training Phase | | | QPI Connect Phase | | Optical Active |
|---|---|---|---|---|---|---|---|---|---|
| State | Disabled | OCLd | OCL1 | OTR Resume | OTP Train Pattern | OTD Train Pattern | QPI Crdy Ready Pattern | QPI Drdy Ready Pattern | OActive QPI Data |
| O_Data: | | | | | | | | | |
| O_Clk: | | LSOP | LSOP | O_FWD_CLK | O_FWD_CLK | O_FWD_CLK | O_FWD_CLK | O_FWD_CLK | O_FWD_CLK |

In one embodiment, there is a local Gasket Interface between Q2S gasket chip 110 and S2Q gasket chip 120 that synchronizes the optical Tx and Rx activities of the links between the two components. This interface is driven from S2Q gasket 120 and causes the Q2S gasket chip 110 to transition states and phases accordingly. One embodiment of this interface is defined in Table 2.

Table 2

| Signal Name | Description |
|---|---|
| CLd_detect | S2Q gasket asserts when LSOP CLd or CL1 rate is detected. |
| CL1_detect | S2Q asserts when LSOP CL1 rate is detected. |
| CLK_detect | Asserted by local S2Q when receiving the O_FWD_CLK from the remote Gasket |
| P_lock[0:1] | Asserted by S2Q upon pattern word lock on PRBS-9 pattern within the local S2Q gasket for each half of the link. |
| OT_sync | Asserted by S2Q upon recognizing inverted PRBS-9 pattern. Acknowledges the remote gasket has data word lock. |
| OT_done[0:1] | Asserted by S2Q upon receiving SYNC with done status bit set. Indicates the remote S2Q gasket status of the P_lock[0:1] respectively. |
| C_Low_Term | Asserted by the S2Q upon detecting the low impedance termination state of the QPI Agent CLK_Rx. This can happen at anytime during the optical initialization sequence. |
| QPI_rdy | Asserted by the S2Q upon receiving the SYNC: QPI_RDY status and C_Low_Term is active. |
| CLK_spd | S2Q has received the Clk_Speed message |
| D_Low_term | Asserted by the S2Q upon detecting the low impedance state of the QPI agent DRx. |

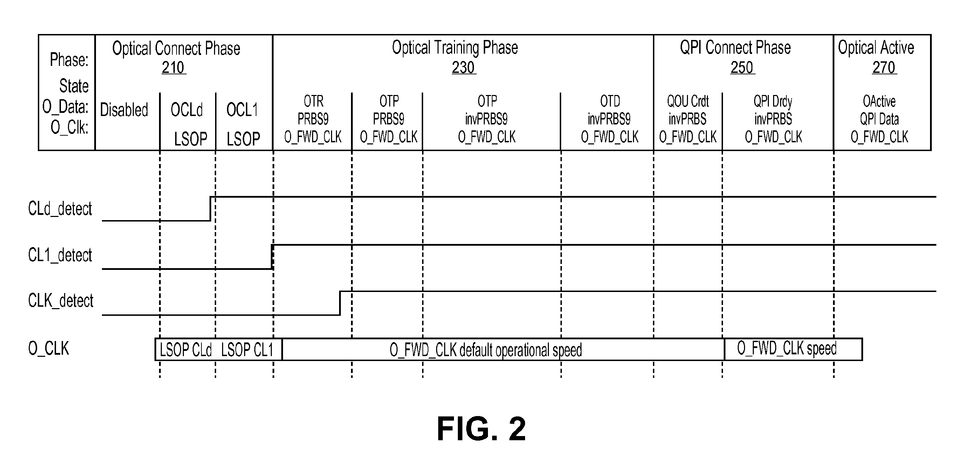

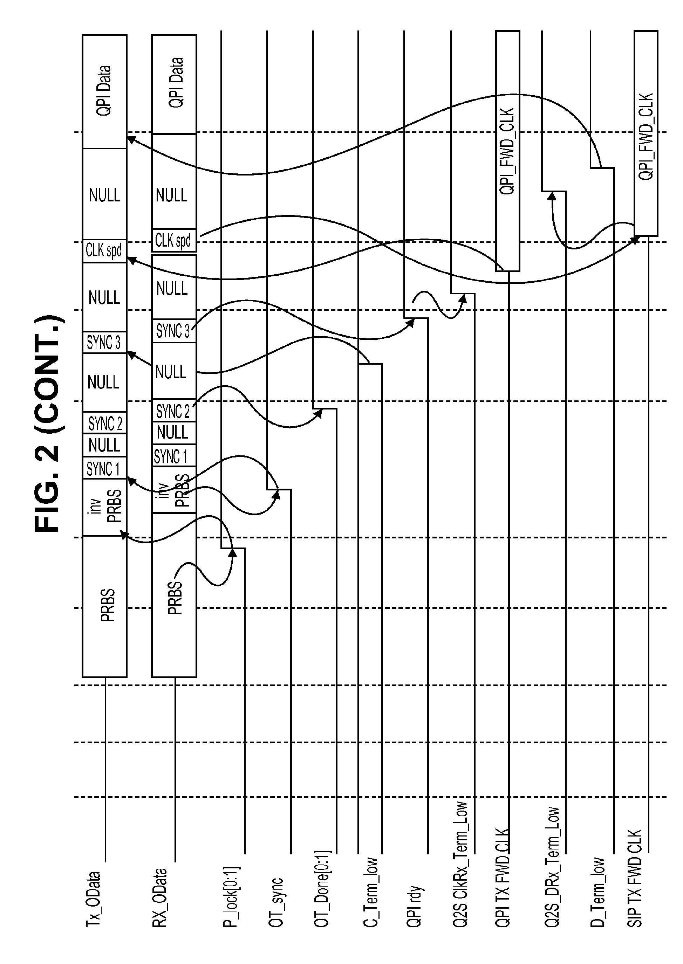

**Figure 2** is a timing diagram of one embodiment of a gasket interface signal initialization process. In one embodiment, in optical connect phase 210, The optical module enters the Optical Connect state from either a hard/cold reset, warm reset, or from an In Band Reset (IBreset), detected on the electrical (e.g., QPI) interface. The function of this state is to establish optical connection of the link. In one embodiment, upon entering Optical Connect Phase 210, S2Q gasket chip 120 will disable termination (in high impedance state), on all Clock and Data Rx lanes interfacing on the electrical side.

In one embodiment, optical connect phase 210 includes three levels: Disabled, Optical Connect level Default State (OCLd), and Optical Connect Level 1 (OLC1). In one embodiment, in the disabled level from assertion of power good or cold reset, the optical domain goes to a disabled state. S2Q gasket chip 120 will disable termination (in high impedance state), on all Clock and data RX lanes interfacing on the electrical side. In the disabled state all lasers are turned off. All logic states are initialized to their power-on reset state. After the release of the Reset signal the optical module will enter the Optical Connect state. In one embodiment, All PLL(s) are locked during the Disabled State.

In one embodiment, in the OCLd state the optical module will transmit Low Speed Optical Pulses, LSOP, across the optical clock lanes, O_CLK, between the optical modules that comprise the link. In one embodiment, the LSOP is at the defined CLd rate and duty cycle using the Low Speed Laser Enable, LSLE. In one embodiment, the LSLE signal output turns the laser on and off versus using the higher power modulator circuit. In one embodiment, this is done only on the clock forward lanes in this state to determine initial optical connection of the link.

In one embodiment, in this state Q2S gasket chip 110 will hold its Rx termination in a high Impedance state for both the Clock and Data lanes. This will prevent the electrical agent (e.g., 190 in Figure 1) from advancing beyond the Clock Detection state of the electrical link initialization protocol.

In one embodiment, S2Q gasket chip 120 listens on the receive LSOD signal for light detection from the remote optical module. In one embodiment, when S2Q gasket 120 receives three consecutive LSOP it will assert the CLd_detected signal to notify the local Q2S gasket chip 110 that it is receiving pulses. Note it is possible to receive LSOP at the CL1 rate depending on the order in which cables were connected. In this case S2Q gasket chip 120 will count 16 consecutive CL1 pulses before activating the CLd_dectect signal.

In one embodiment, Q2S gasket chip 110 will stay in the OCLd state for a minimum of TCLD_sync time that is defined in the CSR register. In this embodiment, Q2S gasket chip 110 will transition to the OCL1 state upon the assertion of the CLd_dectect signal and the expiration of the TCLD_sync timer.

In one embodiment, Optical Connection Level 1 state indicates that S2Q gasket chip 120 is receiving LSOP on the clock lanes and has asserted the CLd_detect signal. In one embodiment Q2S gasket chip 110 acknowledges the CLd_dectect by sending LSOP on the O_CLK lanes at the defined CL1 rate. When S2Q gasket chip 120 receives two consecutive CL1 pulses, (after it has asserted CLd_detect), it will assert the CL1_detect signal causing the local Q2S gasket chip 110 to transition to the Optical Training Phase.

In one embodiment, if Q2S gasket chip 110 ceases to receive LSOP on the O_CLK lanes for the inactive timeout period, it will release the CLd_detect and the CL1_detect signals. Then Q2S gasket chip 110 will transition back to the OCLd state and cease sending the LSOP for the LSOP re-sync time period to synchronize the optical connection sequence.

In on embodiment, in the OCL1 state Q2S gasket chip 110 will hold its Rx termination in a high Impedance state for both the Clock and Data lanes. This will prevent the electrical agent from advancing beyond the Clock Detection state of the QPI initialization protocol.

The purpose of the Optical Training Phase 230 is to establish the optical domain of the link at full data rate on both clock and data lanes. In this phase the O_FWD_CLK will begin transmitting during the Training Resume state at the operational clock rate using the modulator output. In the mean time Q2S gasket chip 110 will begin transmitting a preselected pattern (e.g., the PRBS-9 pattern) on the data lanes for training the link.

In the Optical Training Resume state, OTR, the optical fiber connection has been established on both ends of the optical link. In this state the Q2S gasket will stop sending LSOP and begin sending the O_FWD_CLK using the modulated output. The clock rate will be sent at the Operational Clock Speed, (e.g., 3.2 GHz) generated from the Reference Clock PLL. An alternative Slow Mode operation is described elsewhere. When the S2Q Gasket locks on the O_FWD_CLK it will assert the CLK_detect signal and transition the Optical Training Pattern state.

In the Optical Training Pattern state, the purpose is to train the optical link and to establish the electrical lane phase relationship of the multiplexed data on the optical lane to the optical forward clock. In one embodiment, this is done by transmitting a predetermined (e.g., PRBS 9) pattern across the optical data lane with the even bits (0, 2, 4, ...) generated on lane A of the data lane bundle and the odd bits (1, 3, 5, ...) on lane B of the data lane bundle. In one embodiment, an extra bit is appended to the standard 511 bit stream to provide an even number of bits. The demux lane orientation is derived from synchronizing high speed data path control with the word lock pattern.

In one embodiment, the data lock Timer will begin when one of the P_lock[0:1] is asserted and is disabled when both signals are asserted. If the timer expires the gasket assumes that it is unable to achieve a pattern lock and will disable the link half that has not asserted its pattern lock signal. It will then proceed with the optical initialization of the optical domain in half link mode. The gasket will remain in the OTP state if the neither P_lock signal is asserted.

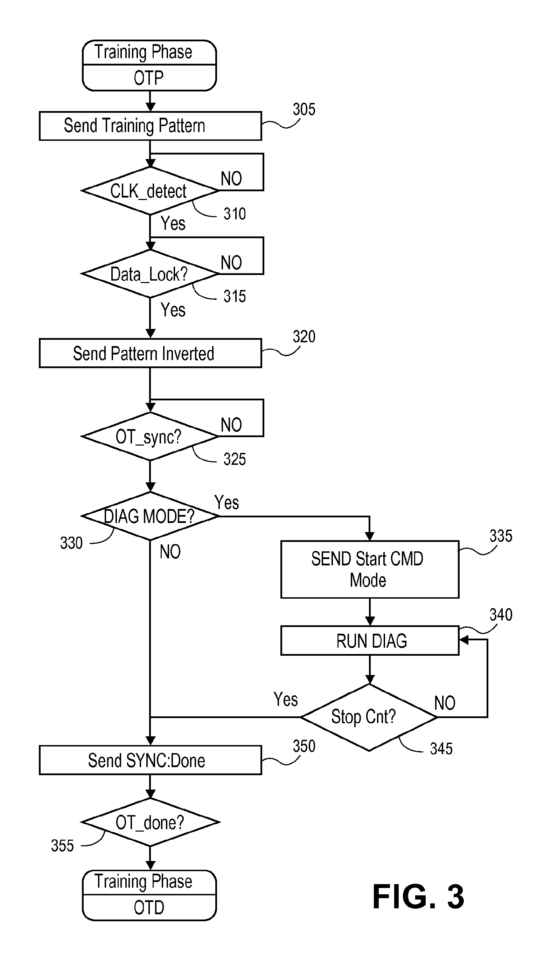

**Figure 3** is a flow diagram of one embodiment for Q2S gasket operation during the optical training pattern state. In one embodiment, during the optical training pattern state the Q2S gasket sends a predetermined training pattern, 305. In one embodiment, this is the PRBS-9 training pattern; however, other training patterns can also be used.

The Q2S gasket waits for a clock signal from the S2Q gasket to be received, 310. In one embodiment, In the OTP state, (Clk_detect asserted), the S2Q will train on the incoming data stream present on the data lanes. When It has successfully locked on the word pattern on all the data lanes contained within the link half, 315, the S2Q gasket will assert the corresponding P_lock[0:1] signal.

In one embodiment, once the P_lock signal is asserted the Q2S gasket will transmit the inverted preselected (e.g., PRBS-9) pattern on one of the data lanes for the corresponding link half, 320. This acts as an acknowledgment to the remote end that it is receiving and has locked on the bit stream. In one embodiment, the Q2S does not need to wait for both P_lock signals or the P_lock timeout to be asserted to send the inverted data. Note that it is possible to receive the inverted PRBS pattern prior achieving local pattern lock. The lock circuitry will need to comprehend either the non-inverted or inverted pattern in this case.

Upon the assertion of the OT_sync signal, 325, the Q2S gasket will send the in band SYNC message with the P_lock and the Training Done status, 350. If the Gasket is in the Diagnostic mode, 330, the done status is not sent. In diagnostic mode, a start command is sent, 335, and diagnostics are run, 340, until a stop command is received, 345. The done status is sent, 350, after the diagnostic mode has completed to advance the optical link from the training phase. The Q2S gasket will send the SYNC message with the QPI_rdy status indicating that its local QPI agent is ready to send the FWD clock and that optical training is complete (OT_done), 355.

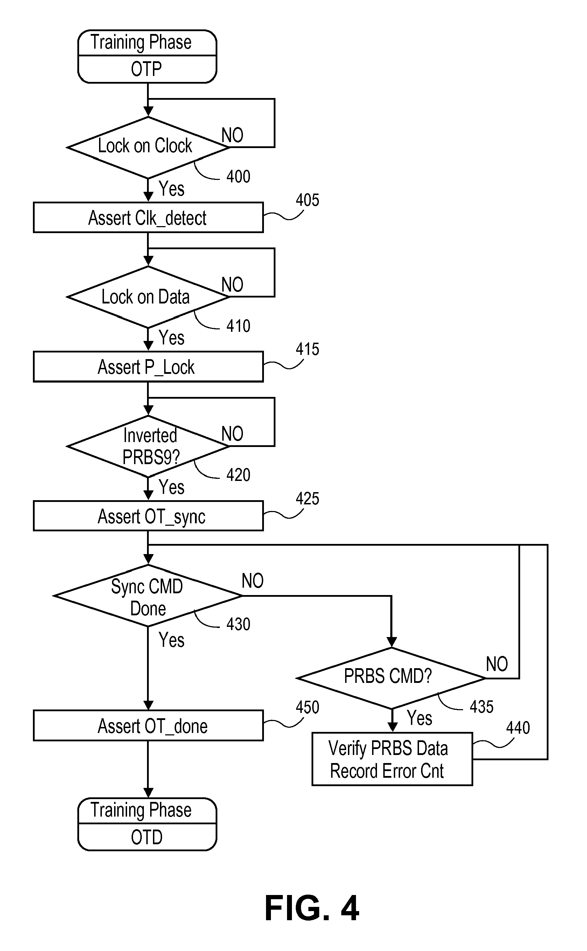

**Figure 4** is a flow diagram of one embodiment for S2Q gasket operation during the optical training pattern state. In one embodiment, The S2Q receives the forwarded clock signal from the Q2S gasket. After achieving bit lock on the clock signal, 400, the S2Q gasket will assert the Clk_detect signal, 405, to the Q2S gasket transitioning to the optical training state. The Q2S gasket continues to transmit the training (e.g., PRBS-9) pattern on the data lanes.

In one embodiment, in the OTP state, (Clk_detect asserted), the S2Q gasket will train on the incoming data stream present on the O_DRx lanes. When It has successfully locked on the word pattern on all the data lanes contained within the link half, 410, the S2Q gasket will assert the corresponding P_lock[0:1] signal, 415. In one embodiment, after recognizing the inverted training pattern for a minimum number (e.g., 2, 3, 4) of successful sequences on both halfs of the link, 420, the S2Q gasket will assert the OT_sync signal, 425. In one embodiment, if a time out occurs on the P_lock, then the OT_sync signal is asserted and the initialization sequence continues with the link half that has completed the training. The assertion of the OT_sync indicates that the remote S2Q Gasket has data pattern lock and that the local gasket has received the acknowledgement as indicated by the inverted training pattern. The S2Q receives the SYNC message with the Done status bit active, 430, it asserts the OT_done[0:1] signals, 450, according to the P_lock status sent in the message.

At the conclusion of both Figures 3 and 4, the Q2S and S2Q gaskets are in the Optical Training Done (OTD) state. The purpose of the optical Training Done state is to synchronize the electrical agent readiness with the completion of the optical training. In one embodiment, the Q2S gasket will continue in this state transmitting the inverted training pattern until it detects that the electrical agent is in the low impedance state. Note that the electrical agent may have enabled the low impedance state at any time during the optical initialization sequence.

Returning to Figure 2, QPI connection phase 250 is responsible for establishing the QPI Agent electrical connection to the optical domain, (gasket components). In this phase the QPI Clock detect state from the remote QPI Agent is synchronized with the QPI clock detect state of the local QPI agent as indicated by the QPI_rdy signal of the S2Q Gasket. In the QPI Data Ready state, QPI Drdy, the S2Q Gasket will sense the data lane inputs from the QPI agent. When it senses a DC value, (1 or 0), it will transition the internal data lanes from the pattern generator to the data lanes from the QPI agent. In the Optical Active state the SiP Module is transparent to the QPI Link.

In alternate embodiments, protocols other than QPI can be used with training sequences of other lengths, scrambled with other PRBS patterns and/or interspersed with other patterns useful for training and/or flit lock.

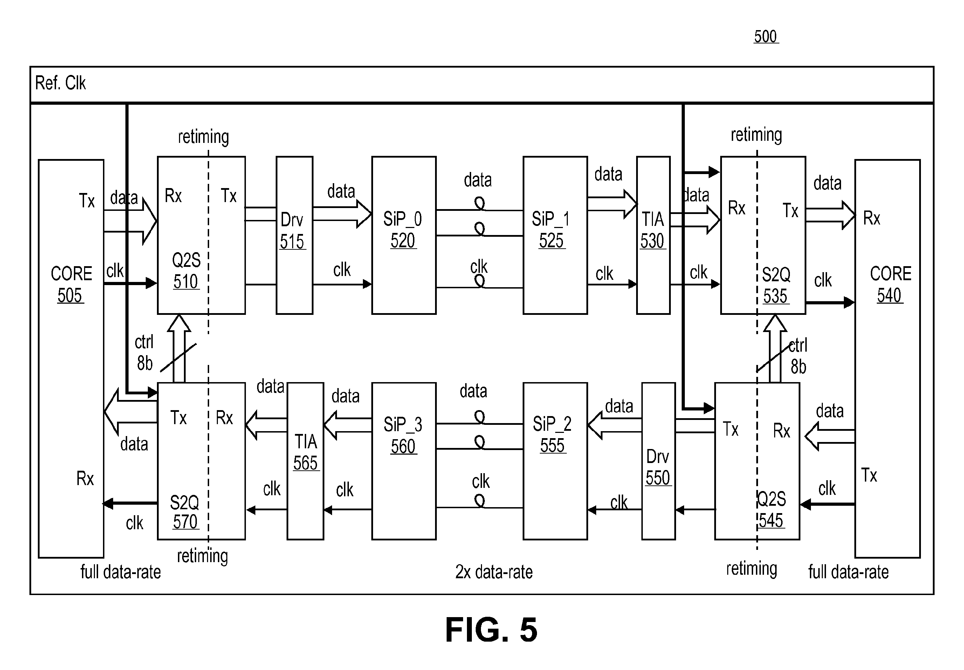

**Figure 5** is a block diagram of one embodiment of an optical memory extension (OME) system. In one embodiment, the system architecture of Figure 5 includes a gasket chip microarchitecture design to interface processing core QPI end agents with optical interconnect extension with Tx and Rx building blocks and implementation example circuits.

In one embodiment, the gasket chip has two types of modules. Q2S gasket 510 and Q2S gasket 545 are the same type of module that receives signals from a QPI end agent (e.g., core 505, core 540) and transmit the signals to a SiP modulator driver module (e.g., 515, 550). In the description that follows, modules of this type are referred to as Q2S (QPI2SIP) module or Tx gasket.

In one embodiment, the Q2S module (e.g., 510, 545) receives differential data signals in 20 lanes at QPI native speed (e.g., 6.4 Gb/s, 8 Gb/s, 9.6 Gb/s, 11.2 Gb/s, 12.8 Gb/s), and differential forwarded-clock in one clock lane at half-data-rate frequency (correspondingly, 3.2 GHz, 4 GHz, 4.8 GHz, 5.6 GHz, and 6.4 GHz) from a QPI end agent (e.g., 505, 540). Other operating frequencies can also be supported. Then, Q2S module (e.g., 510, 545) will ensure the data signals are properly sampled with half-rate samplers, retimed with a synchronization buffer, serialized (2:1) into double-rate data streams (correspondingly, 12.8 Gb/s, 16 Gb/s, 19.2 Gb/s, 22.4 Gb/s, 25.6 Gb/s), and transmitted to SiP modulator driver modules (e.g., 515, 550). Hence, in one embodiment, the outputs of Q2S have 10 data lanes at double-data-rate and one clock lane at half-rate frequency. In an alternate embodiment, the clock lane may be absent and any or all of the data lanes can be used in place of the clock lanes.

In one embodiment, the S2Q module (e.g., 535, 570) receives the differential data signals in 10 lanes at doubled-data-rate and the differential clock signals in one clock lane at half-rate frequency from a TIA module (e.g., 530, 565). Similarly, S2Q modules (e.g., 535, 570) will ensure the signals are properly sampled with quad-rate samplers, retimed with a synchronization buffers, serialized (2:1) into full-rate data streams, and transmitted to a different QPI end agent (e.g., 540, 505). Hence, the outputs of Q2S (e.g., 535, 570) get back to 20 data lanes at QPI native speed and one clock lane at half-rate frequency. In one embodiment, the operations between gasket Q2S to gasket S2Q (e.g., 510 to 535 and 545 to 570) should be transparent to the QPI end agents (505, 540) except for the induced latency.

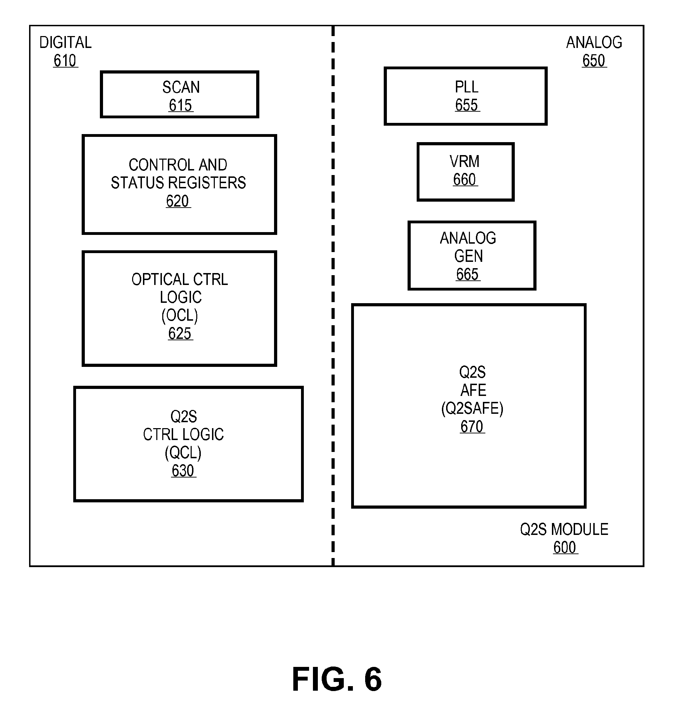

**Figure 6** is a top-level diagram of one embodiment of a Q2S module. In one embodiment, Q2S module 600 includes two main sections: digital side 610 and analog side 650. In one embodiment, digital side 610 includes scan chain 615, control and status registers 620, optical control logic (OCL) 625 and Q2S control logic (QCL) 630. In one embodiment, analog side 650 includes phase locked loop (PLL) 655, voltage regulator module (VRM) 660, analog generator 665 and Q2S analog front end (Q2SAFE) 670.

The key block in Q2S gasket chip module 600 is Q2SAFE unit 670, which performs data receiving, retiming, 2:1 serializing, and double-rate data transmission to SiP modulator driver. The quality of Q2SAFE design and implementation determines the Gasket Q2S 600 operational speed, latency, and power consumption.

In one embodiment, QCL 625 is the logic that contains several units those control Q2SAFE 670 functions. QCL 625 is not part of the data path, but it provides a buffer synchronization setting, which will result in different latency of the data path. In one embodiment, QCL 625 consists of at least the following functionality for data path control and clock path control.

In one embodiment, in data path control, QCL 625 provides at least link onlining (discussed below), buffer synchronization (Sync_FIFO), Icomp control, Rcomp control, AG and DFE control, PLL control, and DFX control. In one embodiment, in clock path control, QCL 625 provides at least CDR control, forwarded clock activity detection and PLL control

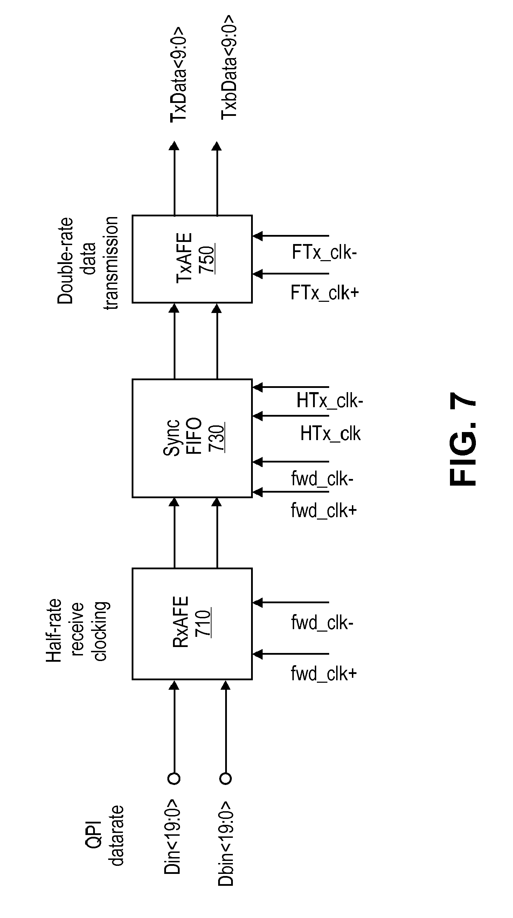

**Figure 7** is a block diagram of one embodiment of a Q2S analog front end (Q2SAFE). Q2SAFE 670 is the data-path of Q2S 600. In one embodiment, Q2SAFE 670 determines the performance of the Q2S chip module 600. In one embodiment Q2SAFE 670 includes 3 major blocks: RxAFE 710, SyncFIFO 730, and TxAFE 750 as shown in Figure 7. The function of RXAFE 710 is to receive, to amplify, to resolve low swing differential analog signal from the SiP interposer input pads, and to sample at the eye center of the data. The function of SyncFIFO 730 is to synchronize the forwarded clock and the gasket transmission clock, to retime the receiving data in order to stop jitter accumulation, and to minimizing the PVT drift. The function of TxAFE 750 is to serialize (2:1) the data streams and to transmit to the SiP driver module.

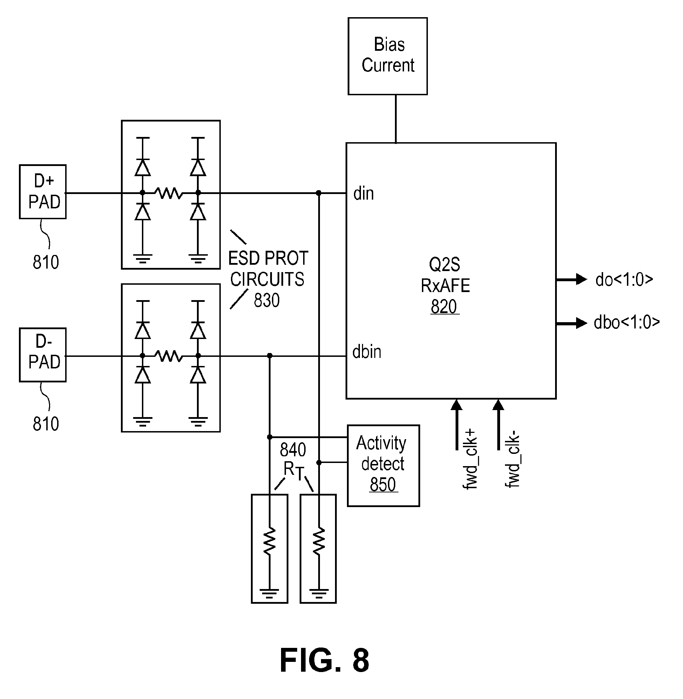

**Figure 8** is a block diagram of one embodiment of a Q2S receiving analog front end (RxAFE). In one embodiment Q2S receiving analog front end (RxAFE) circuit 820 operates to receive, amplify, sample the differential data signals (e.g., from pads 810), and accomplish continuous retraining of phase interpolator (PI). In one embodiment, the output of the Q2S RxAFE 820 will be supplied to the retiming block called Sync_FIFO. In one embodiment, RxAFE block 820 is connected to SiP interposer ball grid array (BGA) pads 810 via ESD protection circuitry 830. The input nodes are also shared with termination $R_T$ 840 and link activity detector 850.

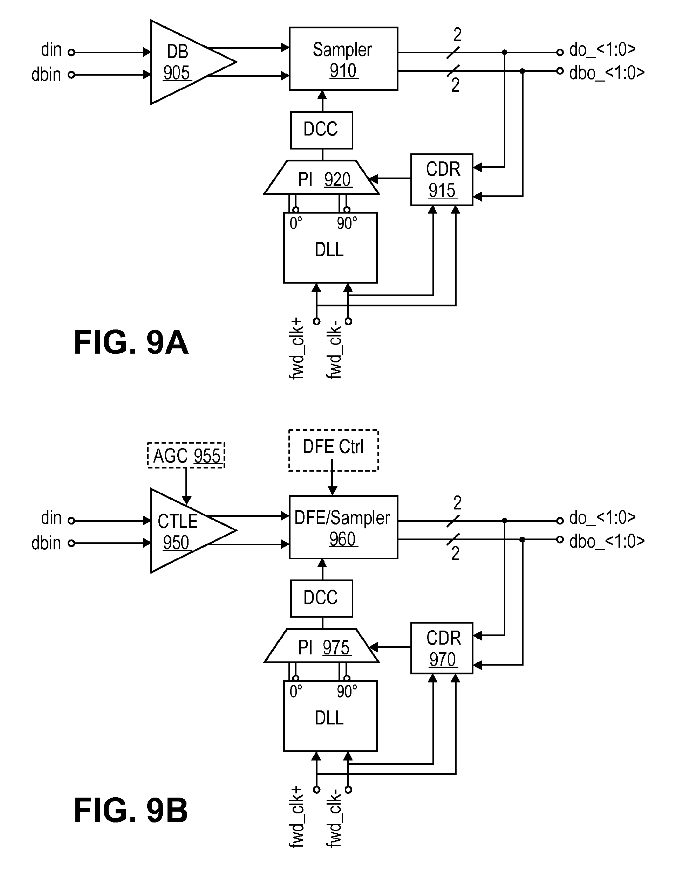

**Figure 9a** is a circuit diagram of one embodiment of a RxAFE architecture for normal speed operation. **Figure 9b** is a circuit diagram of one embodiment of a RxAFE architecture for high speed operation. The internal RxAFE architecture is shown in Figures 9a and 9b presents two circuit options (Fig. 9a) at nominal speed, (e.g., 6.4Gb/s); and (Fig. 9b) at high speed, (e.g., 9.6 Gb/s up to 12.8 Gb/s). Figure 9a is a two-way interleaved receiver architecture consisting of differential buffer 905, followed by sampler 910, retiming recovery CDR 915, phase interpolator 920 to generate sampling clocks.

Figure 9b is a two-way interleaved receiver architecture including continuous-time linear equalizer (CTLE) 950 with automatic gain control (AGC) 955, followed by decision feedback equalizer (DFE)/sampler 960, retiming recovery CDR 970, phase interpolator 975 to generate sampling clocks. In one embodiment, the two options can be implemented by bypass or mux selection to accomplish both architectures in one design.

The equalization technique can compensate the channel effects such as time domain inter-symbol interference (ISI), frequency dependent loss, dispersion and reflection. In one embodiment, two stages of equalization are utilized in the architecture of Figure 9b. In one embodiment, the first stage may be a CTLE implemented using a Cherry-Hooper amplifier to boost channel in frequency. The second stage is DFE, which employs a soft-decision DFE to eliminate ISI. The AGC and DFE approach may take a much longer design time and not so critical for the relatively short and fixed interconnects at the nominal speed.

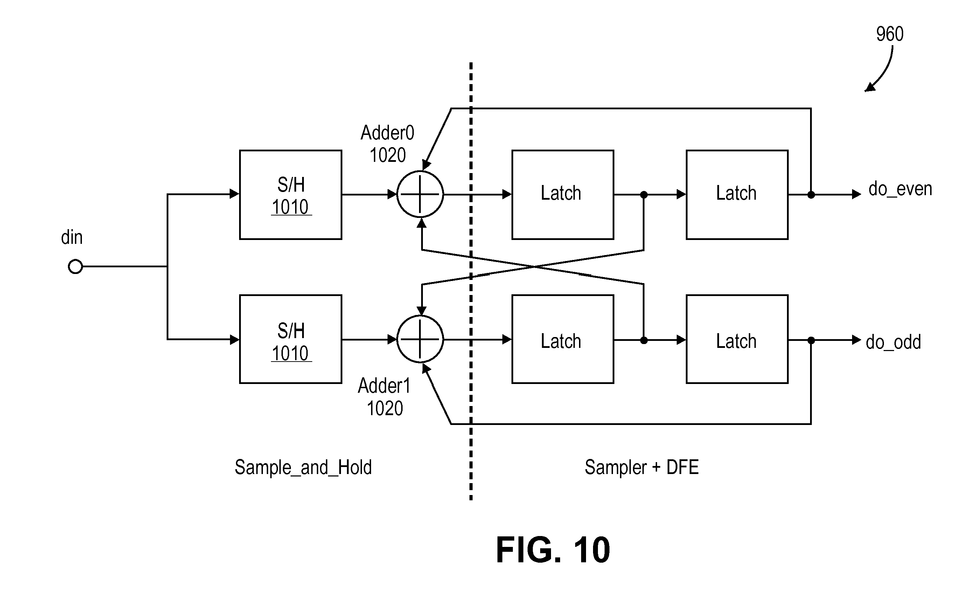

**Figure 10** is a block diagram of one embodiment of a two-tap DFE/sampler circuit. Figure 10 illustrates a half-rate two-tap DFE/Sampler example circuit. This circuit architecture provides a good tradeoff between timing, power, and area. Sample and hold (S/H) circuits 1010 sample and hold the data for 2UI. The early information borrowed at adders 1020 from cross coupled paths allow the node to transition more quickly toward the final value. Circuit speed requirement can be relaxed due to the adder. The 2-Tap DFE architecture can be extended to 4-Tap based on performance requirements.

A delay locked loop (DLL) is a closed loop system that generates a clock signal that has a precise phase relationship with the input clock. In one embodiment, the DLL in the Q2S RXFAE generates differential quadrature phases from the differential forwarded clock (fwd_clk). The differential phases are referred to as I (inphase) {0°, 180°} differential clock pair and Q (quadrture) {90°, 270°} differential clock pair. The DLL design should address the issues such as jitter amplification and quadrature phase error. The jitter amplification is induced from the finite bandwidth of the delay line cells; while the phase error arises from mismatch in phase detection. The four phase outputs are sent from the DLL to the phase interpolators (PI). The PI output

$$PI\ output\ =\ iclk \times icoef + qclk \times qcoef$$

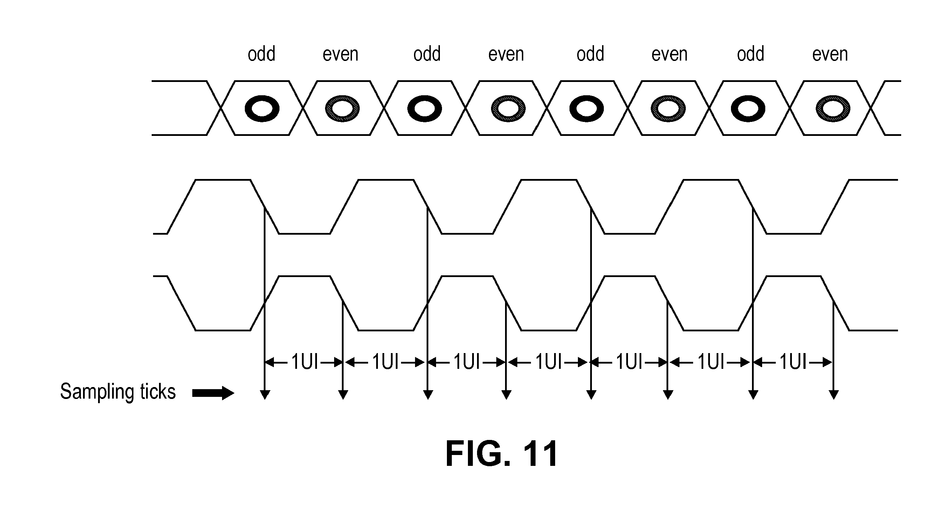

The *icoef* and *qcoef* are generated by the CDR. In one embodiment, the CDR circuit block implements Mueller-Muller phase detection algorithm. It generates phase resolution of 1/64 UI. The outputs of the phase interpolators provide clocks for RxAFE operation. In one embodiment, two bits of data are transmitted per each clock cycle. In one embodiment, the received data is sampled on the falling edge of the clock as shown in **Figure 11.**

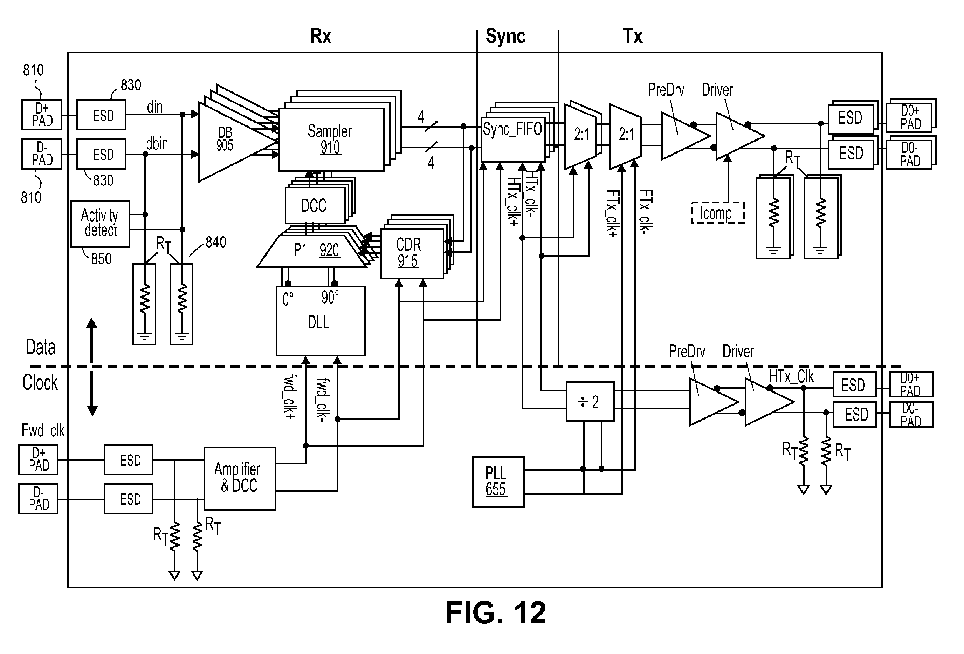

**Figure 12** is a circuit diagram of one embodiment of a complete Q2S data path and clock path architecture. The reference numerals of Figure 12 correspond to the individual blocks illustrated in the figures above. In one embodiment, the gasket architecture described above can function to extend QPI protocol on optical links. It enables seamless transition from QPI to optical link with minimal latency and power impact. It implements retiming circuit to minimize skew introduced by the electrical traces. It takes advantage of high-speed optical links by serializing the electrical streams. The link-on-lining state machine is critical for electrical and optical communications. The programmability of settings provides flexibility for this technology to be adapted by variety of the platforms. It is very robust and easy to implement. It can be easily enhanced for other protocols (e.g. PCI Express) or for more diagnostics (e.g. loopback) or CRC/ECC.

The discussion above for Figures 6-12 has been for embodiments of the Q2S gasket functionality. The discussion that follows is for embodiments of the S2Q gasket functionality.

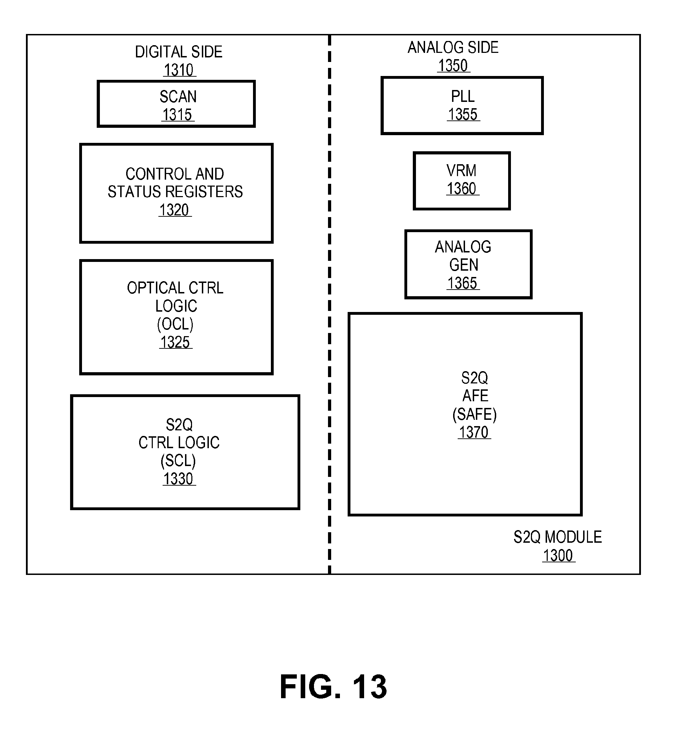

**Figure 13** is a top-level diagram of one embodiment of a S2Q module. In one embodiment, S2Q module 1300 includes two main sections: digital side 1310 and analog side 1350. In one embodiment, digital side 1310 includes scan chain 1315, control and status registers 1320, optical control logic (OCL) 1325 and S2Q control logic (SCL) 1330. In one embodiment, analog side 1350 includes PLL 1355, voltage regulator module 1360, analog bias generator 1365 and S2Q analog front end (S2QAFE or SAFE) 1370. The key block in this gasket chip module is the S2QAFE, which perform data receiving, retiming, 2:1 deserializing, and full rate QPI data transmission to the end agent.

In one embodiment, each of control and status registers 1320 are read/write accessible from the I2C interface. The I2C addressing is the same for both the Q2S and S2Q gasket components. In one embodiment, the registers are mirrored between the two components, thus a write will always write to both components. The software will first write the gasket select register, selecting either the Q2S or S2Q component to select which gasket is to be read. Some status values may not have meaning or not accessible in both the Q2S and S2Q components. A logic level 0 will be returned on read accesses from registers not implemented or from status bits that are not relevant to a particular gasket chip.

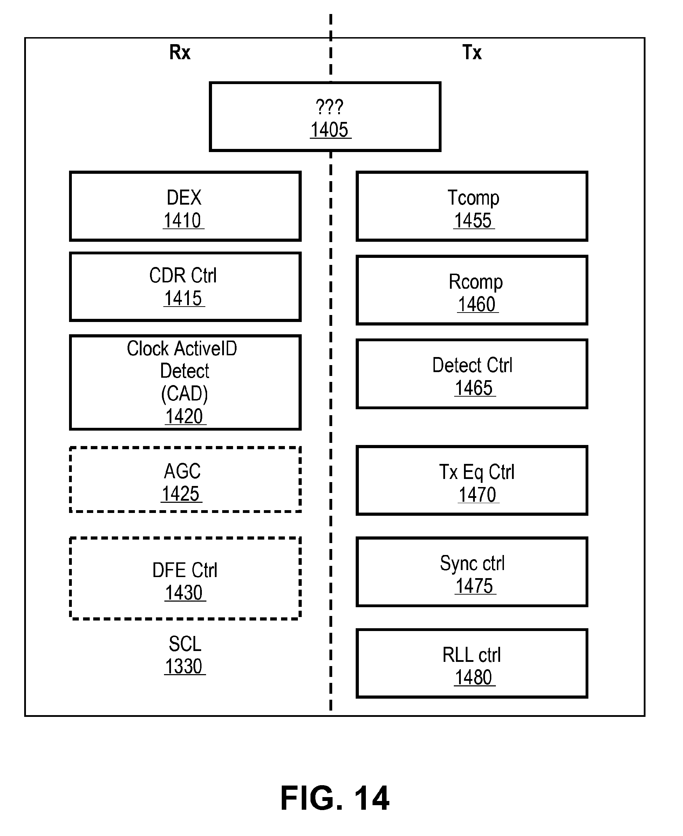

**Figure 14** is a block diagram of one embodiment of S2Q control logic (SCL). In one embodiment, SCL 1330 is the logic that controls several signals of S2QAFE 1370 functions. In one embodiment, SCL 1330 is not part of the data path, but controls Sync_FIFO setting that will result in different latency of the data path. In one embodiment, SCL 1330 controls at least the following functions: link onlining 1410, buffer synchronization, Icomp control 1455, Rcomp control 1460, PLL control 1480, AGC and DFE control (1425 and 1430) if CTLE and DFE functions are utilized, DFX control 1410, transmit equalization control 1470. In one embodiment, SCL 1330 controls the following functions in the clock path: CDR control 1415 and forwarded clock activity detection 1420.

In one embodiment, one SCL manages all of 10 data lanes and one clock lane in two different mode controls. In one embodiment, SCL 1330 will be operating at several clock domains. For example, a scan chain can run at 20+ kHz and a Forwarded clock activity detect unit will run at half-rate clock frequency because this unit monitors the signal transitions of the forwarded clock once it stopped for IBreset. Then, two actions will be taken. First, it will stop moving PI during IBreset. Second, the SCL will duplicate the IBreset clock signals in the TxClk to be sent to the end agent.

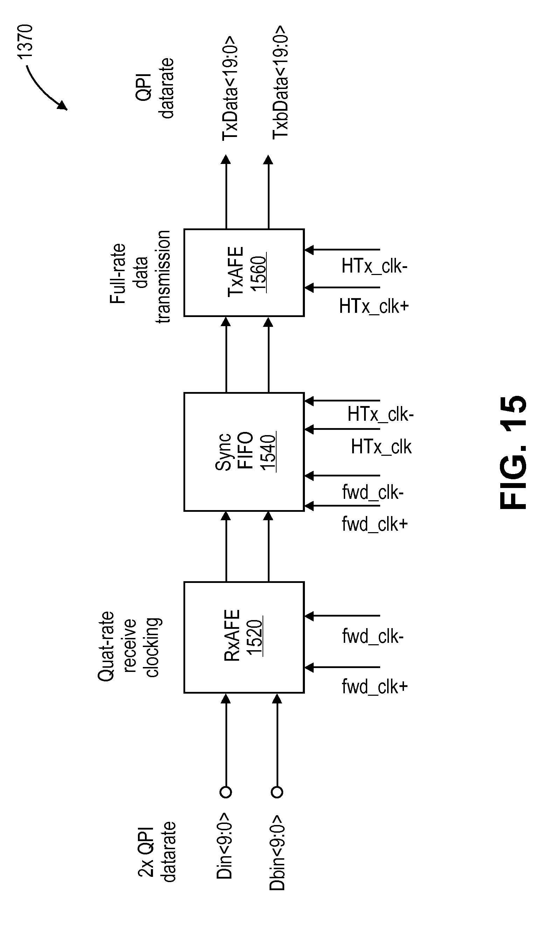

**Figure 15** is a block diagram of one embodiment of a S2Q analog front end. In one embodiment, S2QAFE 1370 is the data-path of S2Q 1300, which determines the performance of the gasket S2Q 1300. In one embodiment, S2QAFE 1370 includes three major blocks: RxAFE 1520, SyncFIFO 1540, and TxAFE 1560. In one embodiment, the function of S2Q_RXAFE 1520 is to receive, to amplify, to resolve low swing differential analog signal at the SiP interposer input pads, and to sample at the data eye center. In one embodiment, the function of S2Q_SyncFIFO 1540 is to synchronize the forwarded clock and transmission clock domain, to retime the receiving data to stop jitter accumulation, and to minimizing the PVT drift. In one embodiment, the function of S2QTxAFE 1560 is to mux (2:1) the data streams and to transmit to the end agent.

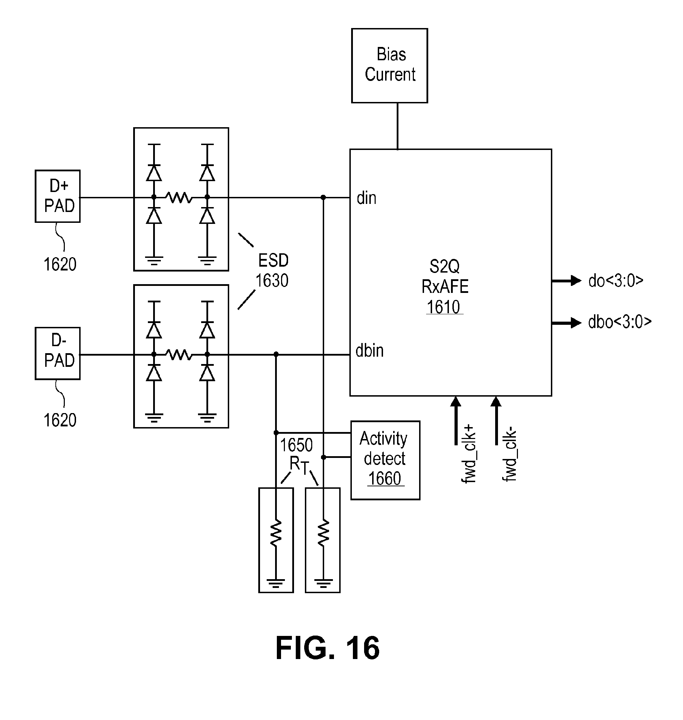

**Figure 16** is a block diagram of one embodiment of a S2Q receive analog front end (RxAFE). In one embodiment, the function of RxAFE 1610 is to receive, amplify, sample the differential data signals, and accomplish continuous retraining of phase interpolator (PI). The output of S2Q RxAFE 1610 will be supplied to the retiming block called Sync_FIFO.

In one embodiment, RxAFE 1610 is connected to SiP interposer ball grid array (BGA) pads 1620 via ESD protection circuitry 1630. The input nodes are also shared with termination $R_T$ 1650 and link activity detector 1660.

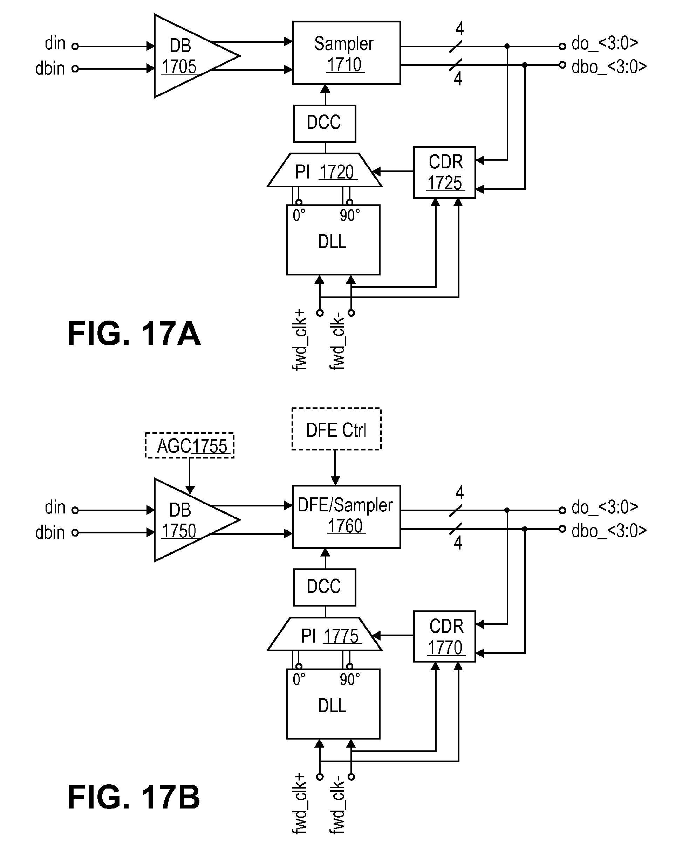

The internal RxAFE of S2Q architecture is shown in **Figures 17a** and **17b ,** which presents two circuit options (a) at nominal speed, e.g. 6.4Gb/s; (b) at high speed, e.g. 9.6 Gb/s up to 12.8 Gb/s. It is a four-way interleaved receiver architecture consisting of (a) a differential buffer , followed by a sampler, a retiming recovery CDR, a phase interpolator to generate sampling clocks; (b) a continuous-time linear equalizer (CTLE) with automatic gain control (AGC), followed by a decision feedback equalizer (DFE)/sampler, a retiming recovery CDR, a phase interpolator to generate sampling clocks. The two options can be implemented by bypass or mux selection to accomplish both architectures in one design.

**Figure 17a** is a circuit diagram of one embodiment of a RxAFE architecture for normal speed operation. **Figure 17b** is a circuit diagram of one embodiment of a RxAFE architecture for high speed operation. The internal RxAFE architecture is shown in Figures 17a and 17b presents two circuit options (Fig. 17a) at nominal speed, (e.g., 6.4Gb/s); and (Fig. 17b) at high speed, (e.g., 9.6 Gb/s up to 12.8 Gb/s). Figure 17a is a two-way interleaved receiver architecture consisting of differential buffer 1705, followed by sampler 1710, retiming recovery CDR 1715, phase interpolator 1720 to generate sampling clocks.

**Figure 17b** is a two-way interleaved receiver architecture including continuous-time linear equalizer (CTLE) 1750 with automatic gain control (AGC) 1755, followed by decision feedback equalizer (DFE)/sampler 1760, retiming recovery CDR 1770, phase interpolator 1775 to generate sampling clocks. In one embodiment, the two options can be implemented by bypass or mux selection to accomplish both architectures in one design.

The equalization technique can compensate the channel effects such as time domain inter-symbol interference (ISI), frequency dependent loss, dispersion and reflection. In one embodiment, two stages of equalization are utilized in the architecture of Figure 17b. In one embodiment, the first stage may be a CTLE implemented using a Cherry-Hooper amplifier to boost channel in frequency. The second stage is DFE, which employs a soft-decision DFE to eliminate ISI. The AGC and DFE approach may take a much longer design time and not so critical for the relatively short and fixed interconnects at the nominal speed.

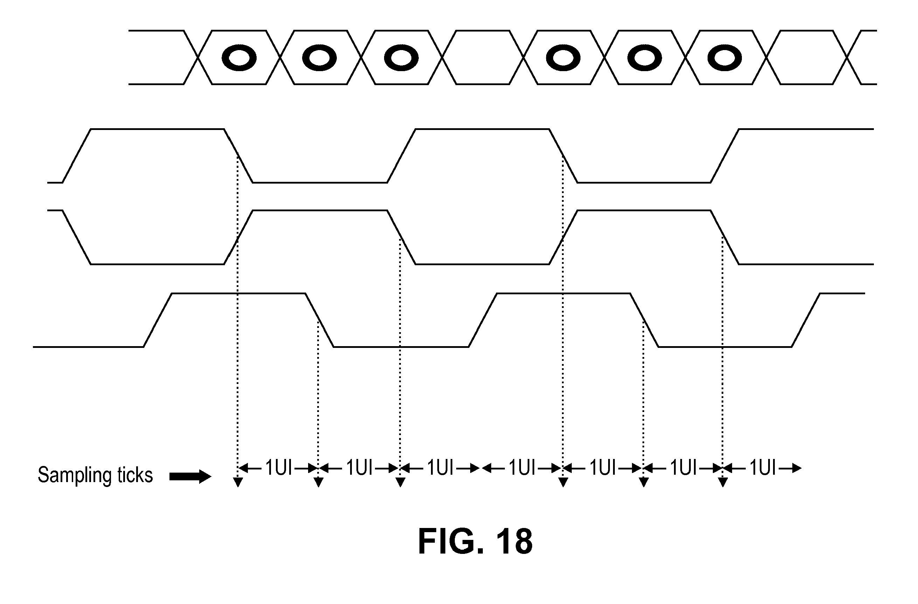

It also uses similar DLL, PI and CDR architecture to generate the sampling clock. The key difference is that it is quad-rate sampling. Four bits of data are transmitted per each clock cycle. The received data is sampled on the falling edge of the clock as shown in **Figure 18.** There are several advantages of doing quad-rate sampling. First, the same Q2S receiving circuits design and layout can be reused. Second, it is more importantly, the design challenges in CDR, DLL and PI, and DFE/sampler are much smaller compared with otherwise full-rate clock speed implementation.

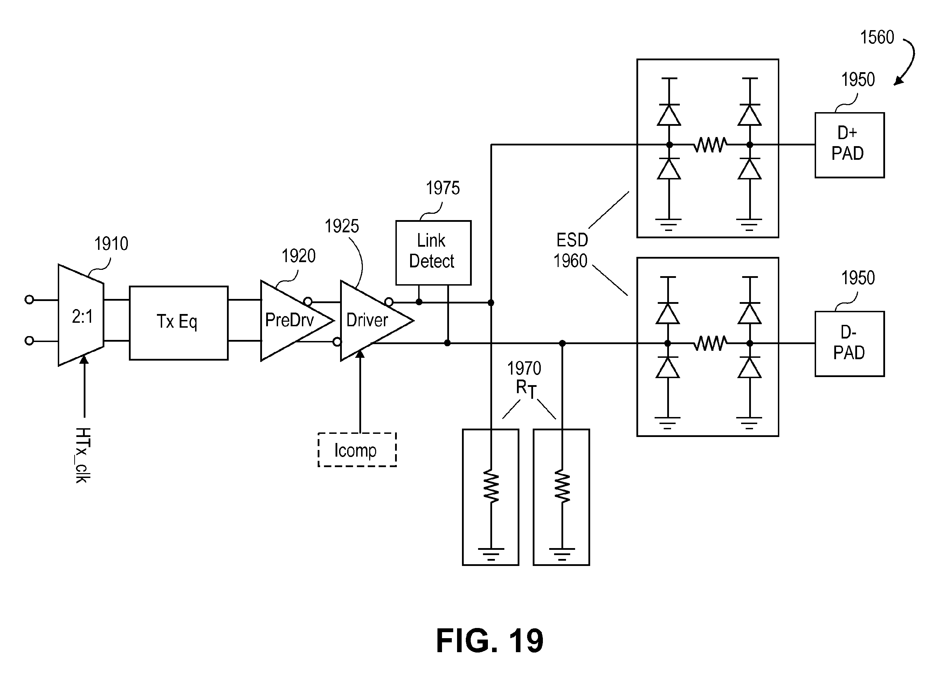

**Figure 19** is a block diagram of one embodiment of a S2Q transmit circuit architecture. This section describes S2Q transmitting data lane analog front end (TxAFE) circuit block (e.g., 1560). In one embodiment, the function of the Tx_AFE is to multiplex (2:1), amplify, and transmit the differential data signals that were feed by SyncFIFO. The output of the Q2S TxAFE will be supplied to the end agent. In one embodiment, after one stage of 2:1 serializer 1910, the data transmission rate is back to the QPI lane speed. The serializer and predriver 1920 and driver 1925 can be implemented with CML circuits to meet signaling speed requirement. In one embodiment, the Tx_AFE block is connected to SiP interposer ball grid array (BGA) pads 1950 via ESD protection circuitry 1960. In one embodiment, the input nodes are also shared with termination $R_T$ 1970 and link detect circuitry 1975.

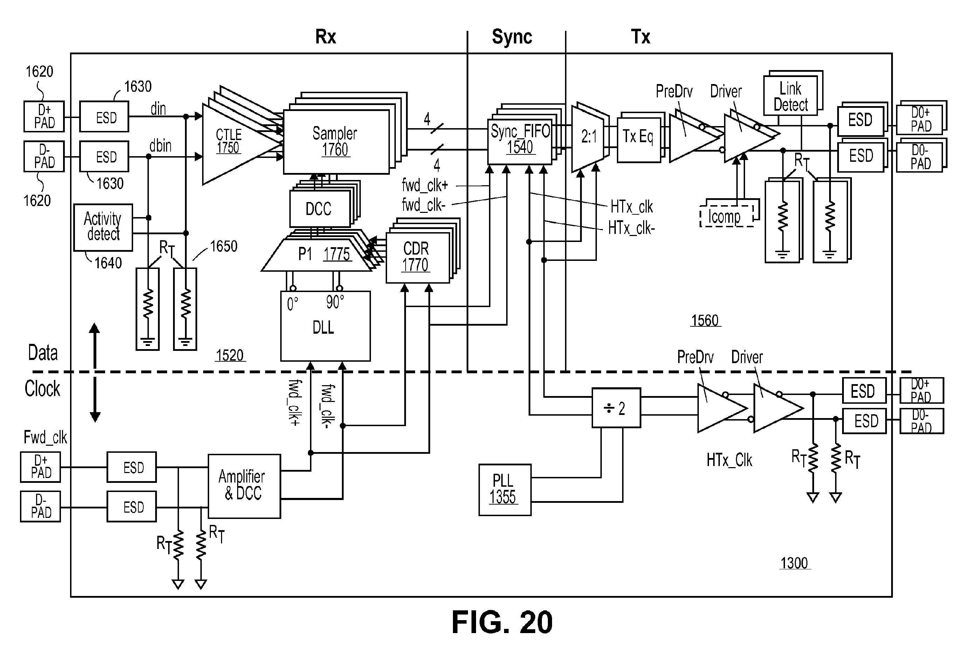

**Figure 20** is a circuit diagram of one embodiment of a complete S2Q data path and clock path architecture. The reference numerals of Figure 20 correspond to the individual blocks illustrated in figures 13-19 above.

The techniques, apparatuses, methods, systems described herein may be implemented using any point-to-point interconnect architecture. As an example, a high performance interconnect (HPI) architecture according to any of the following embodiments may be utilized.

In one embodiment, HPI is a next-generation cache-coherent, link-based interconnect. As one example, HPI may be utilized in high performance computing platforms, such as workstations or servers, where PCIe is typically used to connect accelerators or I/O devices. However, HPI is not so limited. Instead, HPI may be utilized in any of the systems or platforms described herein. Furthermore, the individual ideas developed may be applied to other interconnects, such as PCIe. Moreover, HPI may be extended to compete in the same market as other interconnect, such as PCIe.

To support multiple devices, in one embodiment, HPI includes a Instruction Set Architecture (ISA) agnostic (i.e. HPI is able to be implemented in multiple different devices). In another scenario, HPI may also be utilized to connect high performance I/O devices, not just processors or accelerators. For example, a high performance PCIe device may be coupled to HPI through an appropriate translation bridge (i.e. HPI to PCIe). Moreover, the HPI links may be utilized many HPI based devices, such as processors, in various ways (e.g. stars, rings, meshes, etc.).

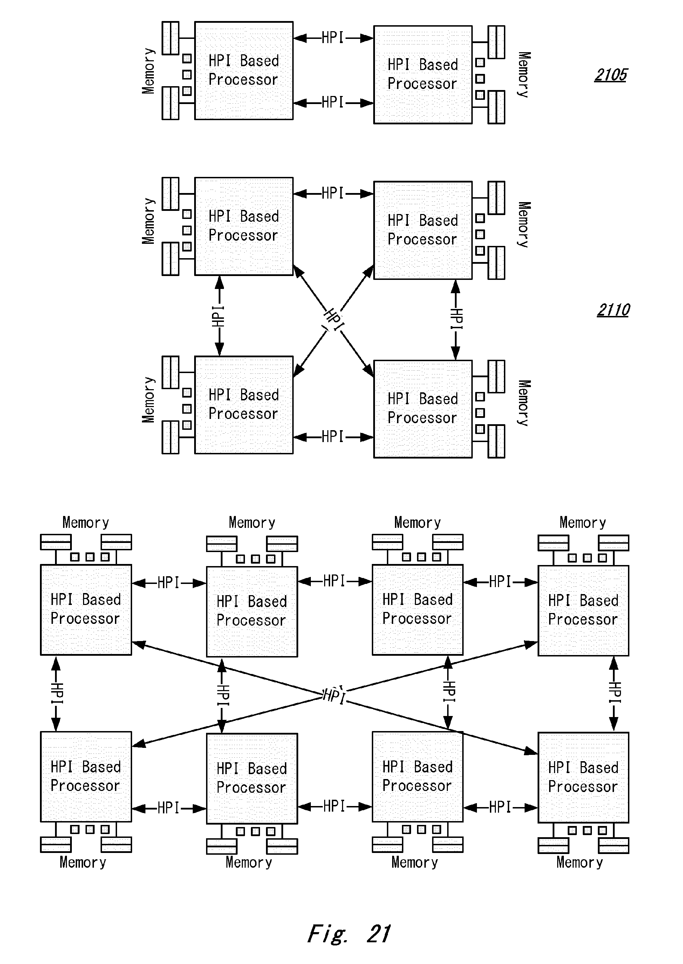

**Figure 21** illustrates an embodiment of multiple potential multi-socket configurations. A two-socket configuration 2105, as depicted, includes two HPI links; however, in other implementations, one HPI link may be utilized. For larger topologies, any configuration may be utilized as long as an ID is assignable and there is some form of virtual path. As shown four-socket configuration 2110 has an HPI link from each processor to another. But in the eight-socket implementation shown in configuration 2115, not every socket is directly connected to each other through an HPI link. However, if a virtual path exists between the processors, the configuration is supported. A range of supported processors includes 2-32 in a native domain. Higher number of processors may be reached through use of multiple domains or other interconnects between node controllers.

The HPI architecture includes a definition of a layered protocol architecture, which is similar to PCIe in that it also includes a layered protocol architecture. In one embodiment, HPI defines protocol layers (coherent, non-coherent, and optionally other memory based protocols), a routing layer, a link layer, and a physical layer. Furthermore, as many other interconnect architecture's HPI includes enhancements related to power managers, design for test and debug (DFT), fault handling, registers, security, etc.

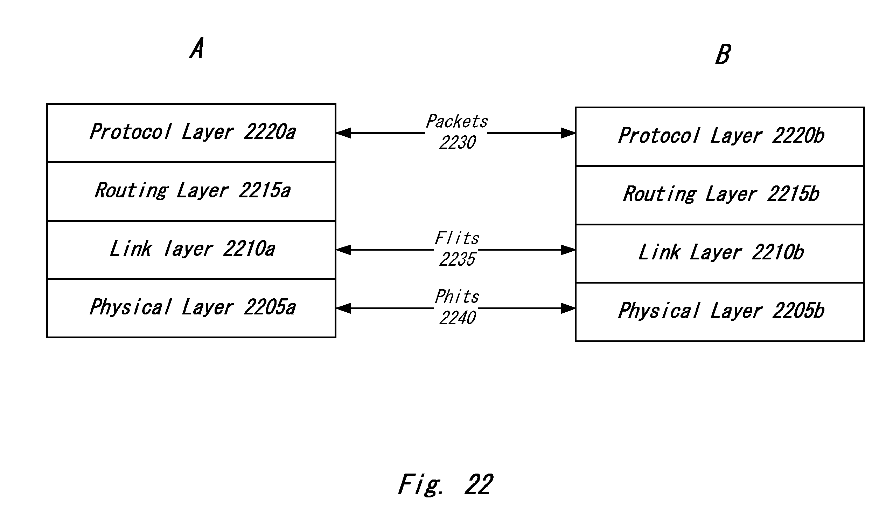

**Figure 22** illustrates an embodiment of potential layers in the HPI layered protocol stack; however, these layers are not required and may be optional in some implementations. Each layer deals with its own level of granularity or quantum of information (the protocol layer 2205a,b with packets 2230, link layer 2210a,b with flits 2235, and physical layer 2205a,b with phits 2240). Note that a packet, in some embodiments, may include partial flits, a single flit, or multiple flits based on the implementation.

As a first example, a width of a phit 2240 includes a 1 to 1 mapping of link width to bits (e.g. 20 bit link width includes a phit of 20 bits, etc.). Flits may have a greater size, such as 184, 192, or 200 bits. Note that if phit 2240 is 20 bits wide and the size of flit 2235 is 184 bits then it takes a fractional number of phits 2240 to transmit one flit 2235 (e.g. 9.2 phits at 20 bits to transmit an 184 bit flit 2235 or 9.6 at 20 bits to transmit a 192 bit flit). Note that widths of the fundamental link at the physical layer may vary. For example, the number of lanes per direction may include 2, 4, 6, 8, 10, 12, 14, 16, 18, 20, 22, 24, etc. In one embodiment, link layer 2210a,b is capable of embedding multiple pieces of different transactions in a single flit, and within the flit multiple headers (e.g. 1, 2, 3, 4) may be embedded within the flit. Here, HPI splits the headers into corresponding slots to enable multiple messages in the flit destined for different nodes.

Physical layer 2205a,b, in one embodiment, is responsible for the fast transfer of information on the physical medium (electrical or optical etc.). The physical link is point to point between two Link layer entities, such as layer 2205a and 2205b. The Link layer 2210a,b abstracts the Physical layer 2205a,b from the upper layers and provides the capability to reliably transfer data (as well as requests) and manage flow control between two directly connected entities. It also is responsible for virtualizing the physical channel into multiple virtual channels and message classes. The Protocol layer 2220a,b relies on the Link layer 2210a,b to map protocol messages into the appropriate message classes and virtual channels before handing them to the Physical layer 2205a,b for transfer across the physical links. Link layer 2210a,b may support multiple messages, such as a request, snoop, response, writeback, non-coherent data, etc.

In one embodiment, to provide reliable transmission cyclic redundancy check (CRC) error checking and recovery procedures are provided by the Link layer 2210a,b in order to isolate the effects of routine bit errors that occur on the physical interconnect. The Link layer 2210a generates the CRC at the transmitter and checks at the receiver Link layer 2210b.

In some implementations, link layer 2210a,b utilized a credit scheme for flow control. During initialization, a sender is given a set number of credits to send packets or flits to a receiver. Whenever a packet or flit is sent to the receiver, the sender decrements its credit counters by one credit, which represents either a packet or a flit, depending on the type of virtual network being used. Whenever a buffer is freed at the receiver, a credit is returned back to the sender for that buffer type. When the sender's credits for a given channel have been exhausted, in one embodiment, it stops sending any flits in that channel. Essentially, credits are returned after the receiver has consumed the information and freed the appropriate buffers.

In one embodiment, routing layer 2215a,b provides a flexible and distributed way to route packets from a source to a destination. In some platform types (for example, uniprocessor and dual processor systems), this layer may not be explicit but could be part of the Link layer 2210a,b; in such a case, this layer is optional. It relies on the virtual network and message class abstraction provided by the Link Layer 2210a,b as part of the function to determine how to route the packets. The routing function, in one implementation, is defined through implementation specific routing tables. Such a definition allows a variety of usage models.

In one embodiment, protocol layer 2220a,b implement the communication protocols, ordering rule, and coherency maintenance, I/O, interrupts, and other higher-level communication. Note that protocol layer 2220a,b, in one implementation provides messages to negotiate power states for components and the system. As a potential addition, physical layer 2205a,b may also independently or in conjunction set power states of the individual links.

Multiple agents may be connect to an HPI architecture, such as a home agent (orders requests to memory), caching (issues requests to coherent memory and responds to snoops), configuration (deals with configuration transactions), interrupt (processes interrupts), legacy (deals with legacy transactions), non-coherent (deals with non-coherent transactions), and others. More specific discussion of the layers for HPI are discussed below.

An overview of a few potential features of HPI includes: not utilizing preallocation at home nodes; no ordering requirements for a number of message classes; packing multiple messages in a single flit (protocol header) (i.e. a packed flit that can hold multiple messages in defined slots); a wide link that may scale from 4, 8, 122, 20, or more lanes; a large error checking scheme that may utilize 8, 16, 32, or as much as 64 bits for error protection; and utilizing an embedded clocking scheme.

The Physical layer 2205a,b (or PHY) of HPI rests above the electrical layer (i.e. electrical conductors connecting two components) and below the link layer 2210a,b, as illustrated in Figure 22. The physical layer resides on each agent and connects the link layers on two agents (A and B) separated from each other. The local and remote electrical layers are connected by physical media (e.g. wires, conductors, optical, etc.).

The physical layer 2205a,b, in one embodiment, has two major phases, initialization and operation. During initialization, the connection is opaque to the link layer and signaling may involve a combination of timed states and handshake events. During operation, the connection is transparent to the link layer and signaling is at a speed, with all lanes operating together as a single link.

During the operation phase, the physical layer transports flits from agent A to agent B and from agent B to agent A. The connection is also referred to as a link and abstracts some physical aspects including media, width and speed from the link layers while exchanging flits and control/status of current configuration (e.g. width) with the link layer. The initialization phase includes minor phases e.g. Polling, Configuration. The operation phase also includes minor phases (e.g. link power management states).

In one embodiment, physical layer 2205a,b is also: to meet a reliability/error standard, tolerate a failure of a lane on a link and go to a fraction of nominal width, tolerate single failures in opposite direction of a link, support hot add/remove, enabling/disabling PHY ports, timeout initialization attempts when the number of attempts has exceeded a specified threshold etc.

In one embodiment, HPI utilizes a rotating bit pattern. For example when a flit size is not aligned with a multiple of the lanes in an HPI link, the flit may not be able to be sent in an integer multiple of transmissions over the lanes (e.g. a 192-bit flit is not a clean multiple of an exemplary 20 lane link. So at x20 flits may be interleaved to avoid wasting bandwidth (i.e. sending a partial flit at some point without utilizing the rest of the lanes). The interleaving, in one embodiment, is determined to optimize latency of key fields and multiplexers in the transmitter (Tx) and receiver (Rx). The determined patterning also potentially provides for clean and quick transitioning to/from a smaller width (e.g x8) and seamless operation at the new width.

In one embodiment, HPI utilizes an embedded clock, such as a 20 bit embedded clock or other number of bit embedded clock. Other high performance interfaces may use a forwarded clock or other clock for inband reset. By embedding clock in HPI, it potentially reduces pinout. However, using an embedded clock, in some implementations, may result in different apparatus and methods to handle inband reset. As a first, example a blocking link state to hold off link flit transmission and allow PHY usage (described in more detail in the Appendix A) is utilized after initialization. As a second example, electrical ordered sets, such as an electrically idle ordered set (EIOS) may be utilized during initialization.

In one embodiment, HPI is capable of utilizing a first bit width direction without a forwarded clock and a second, smaller bit width link for power management. As an example, HPI includes a partial link width transmitting state, where a partial width is utilized (e.g. a x20 full width and a x8 partial width); however, the widths are purely illustrative and may differ. Here, the PHY may handle partial width power management without link layer assist or intervention. In one embodiment, a blocking link state (BLS) protocol is utilized to enter the partial width transmitting state (PWTS). PWTS exit, in one or more implementations, may use the BLS protocol or squelch break detection. Due to absence of a forwarded clock, PWTLS exit may include a re-deskew, which maintains determinism of the link.

In one embodiment, HPI utilizes Tx adaptation. As an example, loopback state and hardware is used for Tx Adaptation. As on example, HPI is capable of counting actual bit errors; this may be able to be performed by injecting specialized patterns. As a result, HPI should be able to get better electrical margins at lower power. When using the loopback state, one direction may be used as a hardware backchannel with metrics sent as part of a training sequence (TS) payload.

In one embodiment, HPI is able to provide latency fixing without exchanging sync counter values in a TS. Other interconnect may perform latency fixing based on such exchanging of a sync counter value in each TS. Here, HPI may utilize periodically recurring Electrically Idle Exit Ordered Sets (EIEOS) as a proxy for the sync counter value by aligning the EIEOS to the sync counter. This potentially saves TS payload space, removes aliasing, and DC balance concerns, as well as simplify the calculation of latency to be added.

In one embodiment, HPI provides for software and timer control of a link state machine transitions. Other interconnect may support a semaphore (hold bit) that is set by hardware on entering an initialization state. Exit from the state occurs when the hold bit is cleared by software. HPI, in one implementation, allows software to control this type of mechanism for entering a transmitting link state or a loop back pattern state. In one embodiment, HPI allows for exit from handshake sates to be based on a software programmable timeout after handshake, which potentially makes test software easier.

In one embodiment, HPI utilizes Pseudo Random Bit Sequence (PRBS) scrambling of TS. As an example a 23-bit PRBS is utilized (PRBS23). In one embodiment, the PRBS is generated by a similar bit size, self-seeded storage element, such as a linear feedback shift register. As one example, a fixed UI pattern may be utilized to scramble with a bypass to an adaptation state. But by scrambling TS with PRBS23, Rx adaptation may be performed without the bypass. In addition, offset and other errors may be reduced during clock recovery and sampling. The HPI approach relies on using Fibonacci LFSRs which can be self seeded during specific portions of the TS.

In one embodiment, HPI supports an emulated slow mode without changing PLL clock frequency. Some designs may use separate PLLs for slow and fast speed. Yet, in on implementation, HPI use emulated slow mode (i.e. PLL clock runs at fast speed; TX repeats bits multiple times; RX oversamples to locate edges and identify the bit.). This means that ports sharing a PLL may coexist at slow and fast speeds. In one example where the multiple is an integer ratio of fast speed to slow speed, different fast speeds may work with the same slow speed, which may be used during the discovery phase of hot attach.

In one embodiment, HPI supports a common slow mode frequency for hot attach. Emulated slow mode, as described above, allows HPI ports sharing a PLL to coexist at slow and fast speeds. When a designer sets the emulation multiple as an integer ratio of fast speed to slow speed, then different fast speeds may work with the same slow speed. So, two agents, which support at least one common frequency, may be hot attached irrespective of the speed at which the host port is running. Software discovery may then use the slow mode link to identify and setup the most optimal link speeds.

In one embodiment, HPI supports re-initialization of link without termination changes. One could provide re-initialization on an inband reset having clock lane terminations changed for the discovery process used in reliability, availability, and serviceability (RAS). In one embodiment, re-initialization for HPI may be done without changing the termination values when HPI includes a RX screening of incoming signaling to identify good lanes.

In one embodiment, HPI supports robust low power link state (LPLS) entry. As an example, HPI may include a minimum stay in LPLS (i.e. a minimum amount of time, UI, counter value, etc that a link stays in LPLS before an exit). Alternatively, LPLS entry may be negotiated and then use an inband reset to enter LPLS. But this may mask an actual inband reset originating from the second agent in some cases. HPI, in some implementations, allows a first agent to enter LPLS and a second agent to enter Reset. The first agent is unresponsive for a time period (i.e. the minimum stay), which allows the second agent to complete reset and then wake up the first agent, enabling a much more efficient, robust entry into LPLS.

In one embodiment, HPI supports features such as debouncing detect, wake and continuous screening for lane failures. HPI may look for a specified signaling pattern for an extended period of time to detect a valid wake from a LPLS thus reducing the chances of a spurious wake. The same hardware may also be used in the background for continuously screening for bad lanes during the initialization process making for a more robust RAS feature.

In one embodiment, HPI supports a deterministic exit for lock step and restart-replay. In HPI, some TS boundaries may coincide with flit boundaries when operating at full width. So HPI may identify and specify the exit boundaries such that lock-step behavior may be maintained with another link. In addition, HPI may specify timers which may be used to maintain lock step with a link pair. After initialization, HPI may also support operation with inband resets disabled to support some flavors of lock-step operation.

In one embodiment, HPI supports use of TS header instead of payload for key initialization parameters. Alternatively, TS payload may be used to exchange init parameters like ACKs and lane numbers. And DC levels for communicating lane polarity may also be used. Yet, HPI may use DC balanced codes in the TS header for key parameters. This potentially reduces the number of bytes needed for a payload and potentially allows for an entire PRBS23 pattern to be used for scrambling TS, which reduces the need for DC balancing the TS.

In one embodiment, HPI supports measures to increase noise immunity of active lanes during partial width transmitting link state (PWTLS) entry/exit of idle lanes. In one embodiment, null (or other non-retryable flits) flits may be used around the width change point to increase noise immunity of active lanes. Additionally, HPI may utilize null flits around the start of PWTLS exit (i.e. the null flits may be broken up with data flits). HPI may also use specialized signaling, whose format may be varied to reduce chances of false wake detects.

In one embodiment, HPI supports use of specialized patterns during PWTLS exit to allow non-blocking deskew. Alternatively, idle lanes may not be deskewed on PWTLS exit since they may maintain skew with help of a forwarded clock. Yet, with use of an embedded clock, HPI may use specialized signaling, whose format may be varied to reduce chances of false wake detects and also allow for deskew without blocking flit flow. This also allows for more robust RAS by seamlessly powering down failing lanes, re-adapting them, and bringing them back online without blocking the flow of flits.

In one embodiment, HPI supports low power link state (LPLS) entry without link layer support and more robust LPLS exit. Alternatively, link layer negotiation may be depended on between pre-designated master and slave to enter LPLS from transmitting link sate (TLS). In HPI, the PHY may handle negotiation using blocking link state (BLS) codes and may support both agents being masters or initiators, as well as entry into LPLS directly from PWTLS. Exit from LPLS may be based on debouncing a squelch break using a specific pattern followed by handshake between the two sides and a timeout induced inband reset if any of this fails.

In one embodiment, HPI supports controlling unproductive looping during initialization. Alternatively, a failure to init (e.g. lack of good lanes) may result in retrying the init too many times, which potentially wastes power and is difficult to debug. In HPI, the link-pair may try to init a set number of times before calling it quits and powering down in a reset state, where software may make adjustments before retrying the init. This potentially improves the RAS of the system.

In one embodiment, HPI supports advanced IBIST (interconnect built in self test) options. In one embodiment, a pattern generator may be utilized, which allows for two non-correlated PRBS23 patterns of maximum length for any pin. In one embodiment, HPI may be able to support four such patterns, as well as provide the ability to control the length of these patterns (i.e. dynamically vary test pattern, PRBS23 length).

In one embodiment, HPI provides advanced logic to deskew lanes. As an example, the TS boundary after TS lock may be used to deskew the lanes. In addition, HPI may deskew by comparing lane PRBS patterns in the LFSR during specific points in the payload. Such deskew might be useful in testchips, which may lack ability to detect TS or state machines to manage the deskew.

In one embodiment, exit from init to link transmitting occurs on a TS boundary with planetary alignment. In addition, HPI may support a negotiated delay from that point. In addition, the order of exit between the two directions may be controlled by using master-slave determinism allowing for one instead of two planetary alignment controls for the link pair.

Some implementations use a fixed 128UI pattern to scramble TS. Others use a fixed 4k PRBS23 to scramble TS. HPI, in one embodiment, allows for using any length PRBS including an entire (8M-1) PRBS23 sequence.

In some architectures adaptation is of fixed duration. In one embodiment, the exit from Adapt is handshaked rather than timed. This means that Adapt times may be asymmetric between the two directions and as long as needed by either side.

In one embodiment, a state machine may bypass states if those state actions don't need to be redone. However, this may lead to more complex designs and validation escapes. HPI doesn't use bypasses - instead it distributes actions such that short timers in each state may be used to perform the actions and bypasses avoided. This potentially makes for more uniform and synchronized state machine transitions.

In some architectures, forwarded clock is utilized for Inband reset and link layer for staging partial width transmitting and for low power link entry. HPI uses block linking state codes similar functions. These codes potentially could have bit errors leading to 'mismatches' at Rx. HPI includes a protocol for dealing with mismatches as well as means to handle asynchronous reset, low power link state and partial width link state requests.

In one embodiment, a 128 UI scrambler is utilized for loopback TS. However, this can lead to aliasing for TS lock when loopback begins; so some architecture's changes the payload to all 0s during this. In another embodiment, HPI utilizes a uniform payload and uses the periodically occurring unscrambled EIEOS for TS lock.

Some architectures utilize scrambled TS during init. In one embodiment, HPI defines supersequences that are combinations of scrambled TS of various lengths and unscrambled EIEOS. This allows more randomized transitions during init and also simplifies TS lock, latency fixing, and other actions.

Returning to Figure 22, an embodiment of a logical block for link layer 2210a,b is illustrated. In one embodiment, Link Layer 2210a,b guarantees reliable data transfer between two protocol or routing entities. It abstracts Physical layer 2205a,b from the Protocol layer 2220a,b, is responsible for the flow control between two protocol agents (A, B), and provides virtual channel services to the Protocol layer (Message Classes) and Routing layer (Virtual Networks). The interface between the Protocol layer 2220a,b and the Link Layer 2210a,b is typically at the packet level.

In one embodiment, the smallest transfer unit at the Link Layer is referred to as a flit which a specified number of bits, such as 192. The Link Layer 2210a,b relies on the Physical layer 2205a,b to frame the Physical layer 2205a,b's unit of transfer (phit) into the Link Layer 2210a,b' unit of transfer (flit). In addition, the Link Layer 2210a,b may be logically broken into two parts, a sender and a receiver. A sender/receiver pair on one entity may be connected to a receiver/sender pair on another entity. Flow Control is often performed on both a flit and a packet basis. Error detection and correction is also potentially performed on a flit level basis.

In one embodiment, flits are expanded 192 bits. However, any range of bits, such as 81-256 (or more) may be utilized in different variations. Here, the CRC field is also increased (e.g. 16 bits) to handle a larger payload.

In one embodiment, TIDs (Transaction IDs) are 11 bits in length. As a result, pre-allocation and the enabling of distributed home agents may be removed. Furthermore, use of 11 bits, in some implementations, allows for the TID to be used without having use for an extended TID mode.

In one embodiment, header flits are divided into 3 slots, 2 with equal size (Slots 0 and 1) and another smaller slot (Slot 2). A floating field may be available for one of Slot 0 or 1 to use. The messages that can use slot 1 and 2 are optimized, reducing the number of bits needed to encode these slots' opcodes. When a header needing more bits that Slot 0 provides enters the link layer, slotting algorithms are in place to allow it to take over Slot 1 payload bits for additional space. Special control (e.g. LLCTRL) flits may consume all 3 slots worth of bits for their needs. Slotting algorithms may also exist to allow individual slots to be utilized while other slots carry no information, for cases where the link is partially busy. Other interconnect may allow a single message per flit, instead of multiple. The sizing of the slots within the flit, and the types of messages that can be placed in each slot, potentially provide the increased bandwidth of HPI even with a reduced flit rate.

In HPI, a large CRC baseline may improve error detection. For example, a 16 bit CRC is utilized. As a result of the larger CRC, a larger payload may also be utilized. The 16 bits of CRC in combination with a polynomial used with those bits improves error detection. As an example, there are a minimum number of gates to provide 1) 1-4 bit errors detected 2) errors of burst length 16 or less are detected.

In one embodiment, a rolling CRC based on two CRC-16 equations is utilized. Two 16 bit polynomials may be used, the polynomial from HPI CRC-16 and a second polynomial. The second polynomial has the smallest number of gates to implement while retaining the properties of 1) all 1-7 bit errors detected 2) per lane burst protection in x8 link widths 3) all errors of burst length 16 or less are detected.

In one embodiment, a reduced max flit rate (9.6 versus 4 UI) is utilized, but increased throughput of the link is obtained. As a result of the increased flit size, introduction of multiple slots per flit, optimized utilization of payload bits (changed algorithms to remove or relocate infrequently used fields), more interconnect efficiency is achieved.

In one embodiment, part of the support for 3 slots includes 192 bit flit. The floating field enables 11 extra bits of payload for either slot 0 or slot 1. Note if a larger flit is used more floating bits may be used. And as a corollary, if a smaller flit is used, then less floating bits are provided. By allowing a field to float between the two slots, we can provide the extra bits needed for certain messages, while still staying within 192 bits and maximizing the utilization of the bandwidth. Alternatively, providing an 11 bit HTID field to each slot may use an extra 11 bits in the flit which would not be as efficiently utilized.

Some interconnects may transmit Viral status in protocol level messages and Poison status in data flits. In one embodiment, HPI protocol level messages and Poison status are moved to control flits. Since these bits are infrequently used (only in the case of errors), removing them from the protocol level messages potentially increases flit utilization. Injecting them using control flits still allows containment of the errors.

In one embodiment, CRD and ACK bits in a flit allow return of a number of credits, such as eight, or the number of acks, such as 8. As part of the fully encoded credit fields, these bits are utilized as Credit[n] and Acknowledge[n] when Slot 2 is encoded as LLCRD. This potentially improves efficiency by allowing any flit to return the number of VNA Credits and the number of Acknowledges using a total of only 2 bits, but also allowing their definitions to remain consistent when a fully encoded LLCRD return is used.

In one embodiment, VNA vs. VN0/1 encoding (saves bits by aligning slots to same encoding). The slots in a multi-slot header flit may be aligned to just VNA, just VN0, or just VN1. By enforcing this, per slot bits indicating VN are removed. This increases the efficiency of flit bit utilization and potentially enables expanding from 10 bit TIDs to 11 bit TIDs.

Some fields only allow return in increments of 1 (for VN0/1), 2/8/16 (for VNA), and 8 (for Acknowledge). This means that returning a large number of pending Credits or Acknowledges may use multiple return messages. It also means that odd numbered return values for VNA and Acknowledge may be left stranded pending accumulation of an evenly divisible value. HPI may have fully encoded Credit and Ack return fields, allowing an agent to return all accumulated Credits or Acks for a pool with a single message. This potentially improves link efficiency and also potentially simplifies logic implementation (return logic can implement a "clear" signal rather than a full decrementer).

In one embodiment, Routing layer 2215a,b provides a flexible and distributed method to route HPI transactions from a source to a destination. The scheme is flexible since routing algorithms for multiple topologies may be specified through programmable routing tables at each router (the programming in one embodiment is performed by firmware, software, or a combination thereof).

The routing functionality may be distributed; the routing may be done through a series of routing steps, with each routing step being defined through a lookup of a table at either the source, intermediate, or destination routers. The lookup at a source may be used to inject a HPI packet into the HPI fabric. The lookup at an intermediate router may be used to route an HPI packet from an input port to an output port. The lookup at a destination port may be used to target the destination HPI protocol agent. Note that the Routing layer, on some implementations, is thin since the routing tables, and, hence the routing algorithms, are not specifically defined by specification. This allows a variety of usage models, including flexible platform architectural topologies to be defined by the system implementation.

The Routing layer 2215a,b relies on the Link layer 2210a,b for providing the use of up to three (or more) virtual networks (VNs) - in one example, two deadlock-free VNs, VN0 and VN1 with several message classes defined in each virtual network. A shared adaptive virtual network (VNA) may be defined in the link layer, but this adaptive network may not be exposed directly in Routing Concepts, since each Message class and VN may have dedicated resources and guaranteed forward progress.

A non-exhaustive, exemplary list of routing rules includes: (1) (Message class invariance): An incoming packet belonging to a particular message class may be routed on an outgoing HPI port/virtual network in the *same* message class; (2) (Switching) HPI platforms may support the "store-and-forward" and "virtual cut through" types of switching. In another embodiment, HPI may not support "wormhole" or "circuit" switching. (3) (Interconnect deadlock freedom) HPI platforms may not rely on adaptive flows for deadlock-free routing.

With platforms, which use both VN0 and VN1, the 2 VNs together may be used for deadlock-free routing; and (4) (VN0 for "leaf" routers). In HPI platforms, which may use both VN0 and VN1, it is permissible to use *VN0* for those components, whose routers are not used route-through; that is, incoming ports have HPI destinations that terminate at this component. In such a case, packets from different VNs can be routed to VN0. Other rules (for example, movement of packets between VN0 and VN1) may be governed by a platform dependent routing algorithm.

Routing step: A routing step, in one embodiment, is referred to by a routing function (RF) and a selection function (SF). The routing function may take, as inputs, a HPI port at which a packet arrives and a destination NodeID; it then yields as output a 2-tuple - the HPI port number and the virtual network - which the packet should follow on its path to the destination. It is permitted for the routing function to be additionally dependent on the incoming virtual network. Further, it is permitted with the routing step to yield multiple <port#, virtual network> pairs.

The resulting routing algorithms are called adaptive. In such a case, a selection function SF may choose a single 2-tuple based on additional state information which the router has (for example, with adaptive routing algorithms, the choice of a particular port of virtual network may depend on the local congestion conditions). A routing step, in one embodiment, consists of applying the routing function and then the selection function to yield the 2-tuple(s).

Router Table Simplifications: HPI platforms may implement legal subsets of the virtual networks. Such subsets simplify the size of the routing table (reduce the number of columns) associated virtual channel buffering and arbitration at the router switch. These simplifications ay come at the cost of platform flexibility and features. VN0 and VN1 may be deadlock-free networks, which provide deadlock freedom either together or singly, depending on the usage model, usually with minimal virtual channel resources assigned to them.

Flat organization of the routing table may include a size corresponding to the maximum number of *NodeIDs.* With such an organization, the routing table may be indexed by the *destination NodeID* field and possibly by the *virtual network id* field. The table organization can also be made hierarchical with the destination NodeID field being sub-divided into multiple sub-fields, which is implementation dependent. For example, with a division into "local" and "non-local" parts, the "non-local" part of the routing is completed before the routing of the "local" part. The potential advantage of reducing the table size at every input port comes at the potential cost of being forced to assign NodeIDs to HPI components in a hierarchical manner

Routing Algorithm: A routing algorithm, in one embodiment, defines the set of permissible paths from a source module to a destination module. A particular path from the source to the destination is a subset of the permissible paths and is obtained as a series of routing steps defined above starting with the router at the source, passing through zero or more intermediate routers, and ending with the router at the destination. Note that even though an HPI fabric may have multiple physical paths from a source to a destination, the paths permitted are those defined by the routing algorithm.

In one embodiment, the HPI Coherence Protocol is included in layer 2220a,b is to support agents caching lines of data from memory. An agent wishing to cache memory data may use the coherence protocol to read the line of data to load into its cache. An agent wishing to modify a line of data in its cache may use the coherence protocol to acquire *ownership* of the line before modifying the data. After modifying a line, an agent may follow protocol requirements of keeping it in its cache until it either writes the line back to memory or includes the line in a response to an external request. Lastly, an agent may fulfill external requests to invalidate a line in its cache. The protocol ensures coherency of the data by dictating the rules all caching agents may follow. It also provides the means for agents without caches to coherently read and write memory data.

Two conditions may be enforced to support transactions utilizing the HPI Coherence Protocol. First, the protocol maintains *data consistency,* as an example on a per-address basis, among data in agents' caches and between those data and the data in memory. Informally, data consistency may refer to each valid line of data in an agent's cache representing a most up-to-date value of the data and data transmitted in a coherence protocol packet represents the most up-to-date value of the data at the time it was sent. When no valid copy of the data exists in caches or in transmission, the protocol may ensure the most up-to-date value of the data resides in memory. Second, the protocol provides well-defined commitment points for requests. Commitment points for reads may indicate when the data is usable; and for writes they may indicate when the written data is *globally observable* and will be loaded by subsequent reads. The protocol may support these commitment points for both cacheable and uncacheable (UC) requests in the coherent memory space.

The HPI Coherence Protocol also may ensure the *forward progress* of coherence requests made by an agent to an address in the coherent memory space. Certainly, transactions may eventually be satisfied and retired for proper system operation. The HPI Coherence Protocol, in some embodiments, may have no notion of retry for resolving resource allocation conflicts. Thus, the protocol itself may be defined to contain no circular resource dependencies, and implementations may take care in their designs not to introduce dependencies that can result in deadlocks. Additionally, the protocol may indicate where designs are able to provide fair access to protocol resources.

Logically, the HPI Coherence Protocol, in one embodiment, consists of three items: coherence (or caching) agents, home agents, and the HPI interconnect fabric connecting the agents. Coherence agents and home agents work together to achieve data consistency by exchanging messages over the interconnect. The link layer 2210a,b and its related description provides the details of the interconnect fabric including how it adheres to the coherence protocol's requirements, discussed herein. (It may be noted that the division into coherence agents and home agents is for clarity. A design may contain multiple agents of both types within a socket or even combine agents behaviors into a single design unit.).

In one embodiment, HPI does not pre-allocate resources of a Home Agent. Here, a Receiving Agent receiving a request allocates resource to process it. An Agent sending a request allocates resources for responses. In this scenario, HPI may follow two general rules regarding resource allocation. First, an agent receiving a request may be responsible for allocating the resource to process it. Second, an agent generating a request may be responsible for allocating resources to process responses to the request.

For allocation of resources may also extend to HTID (along with RNID/RTID) in snoop requests the potential reduction of using a home agent and forward responses to support responses to Home Agent (and data forwarding to requesting agent).

In one embodiment, home agent resources are also not pre-allocated in snoop requests and forward responses to support responses to the home agent (and data forwarding to the requesting agent.

In one embodiment, there is no pre-allocation of Home resources Ability to send CmpO "early", before Home Agent is finished processing request, when it is safe for requesting agent to reuse its RTID resource. General handling of snoops with similar RNID/RTID in system also part of protocol.

In one embodiment, conflict resolution is performed using an ordered response channel. A Coherence Agent uses RspCnflt as request for a Home Agent to send a FwdCnfltO, which will be ordered with the CmpO (if any already scheduled) for the Coherence Agent's conflicting request.

In one embodiment, HPI supports conflict resolution via an ordered response channel. A Coherence Agent using information from snoop to aid in processing FwdCnfltO, which has no "type" information and no RTID for forwarding data to requesting agent.

In one embodiment, a Coherence Agent blocks forwards for writeback requests to maintain data consistency. But it also allows Coherence Agent to use a writeback request to commit uncacheable (UC) data before processing forward and allows the Coherence Agent to writeback partial cache lines instead of protocol supporting a partial implicit writeback for forwards.

In one embodiment, a read invalidate (RdInv) request accepting Exclusive-state data is supported. Semantics of uncacheable (UC) reads include flushing modified data to memory. Some architecture, however, allowed forwarding M data to invalidating reads, which forced the requesting agent to clean the line if it received M data. The RdInv simplifies the flow but it does not allow E data to be forwarded.

In one embodiment, HPI support an InvItoM to IODC functionality. An InvItoM requests exclusive ownership of a cache line without receiving data and with the intent of performing a writeback soon afterward. A required cache state may be an M state, and E state, or either.

In one embodiment, HPI supports a WbFlush for persistent memory flush. An embodiment of a WbFlush is illustrated below. It may be sent as a result of a persistent commit. May flush write to persistent memory.

In one embodiment, HPI supports additional operations, such as SnpF for "fanout" snoops generated by the Routing Layer. Some architectures don't have explicit support for fanout snoops. Here, a HPI Home agent generates single "fanout" snoop request and, in response, the Routing Layer generates snoops to all peer agents in the "fanout cone". Home agent may expect snoop responses from each of the agent Sections.

In one embodiment, HPI supports additional operations, such as SnpF for "fanout" snoops generated by the Routing Layer. Some architectures don't have explicit support for fanout snoops. Here, a HPI Home agent generates single "fanout" snoop request and, in response, the Routing Layer generates snoops to all peer agents in the "fanout cone". Home agent may expect snoop responses from each of the agent Sections.

In one embodiment, HPI supports an explicit writeback with cache-push hint (WbPushMtoI). In one embodiment, a Coherence Agent writes back modified data with a hint to Home Agent that it may push the modified data to a "local" cache, storing in M state, without writing the data to memory.

In one embodiment, a Coherence Agent may keep F state when forwarding shared data. In on example, a Coherence Agent with F state that receives a "sharing" snoop or forward after such a snoop may keep the F state while sending S state to the requesting agent.

In one embodiment, protocol tables may be nested by having one table refer to another sub-table in the "next state" columns, and the nested table can have additional or finer-grained guards to specify which rows (behaviors) are permitted.

In one embodiment, Protocol tables use row spanning to indicate equally permissible behaviors (rows) instead of adding "Bias" bits to select among behaviors. In one embodiment, action tables are organized for use as functionality engine for BFM

(validation environment tool) rather than having BFM team create their own BFM engine based upon their interpretation.

In one embodiment, HPI supports non-coherent transactions. As an example, a non-coherent transaction is referred to as one that does not participate in the HPI coherency protocol. Non-coherent transactions comprise requests and their corresponding completions. For some special transactions, a broadcast mechanism.

Reference in the specification to "one embodiment" or "an embodiment" means that a particular feature, structure, or characteristic described in connection with the embodiment is included in at least one embodiment of the invention. The appearances of the phrase "in one embodiment" in various places in the specification are not necessarily all referring to the same embodiment.

While the invention has been described in terms of several embodiments, those skilled in the art will recognize that the invention is not limited to the embodiments described, but can be practiced with modification and alteration within the spirit and scope of the appended claims. The description is thus to be regarded as illustrative instead of limiting.

## Claims

1. A system comprising:

   a first electrical logic circuit on a first die to communicate data according to a packetized, point-to-point interconnect protocol according to a full data rate;
   a first gasket circuit coupled to receive the data from the first electrical logic circuit, the first gasket circuit to cause the data to be converted to an optical format to be transmitted at a rate that is at least double the full data rate;
   a second gasket circuit coupled to receive the data in the optical format from the first gasket circuit, the second gasket circuit to cause the data to be converted to an electrical format conforming to the packetized, point-to-point interconnect protocol; and
   a second electrical logic circuit on a second die coupled to receive the data from the first electrical logic circuit.

2. The apparatus of claim 1 wherein the packetized, point-to-point interconnect protocol includes a snoop protocol; or wherein the packetized, point-to-point interconnect protocol manages cache coherence using a write-back protocol; or
   wherein the packetized, point-to-point interconnect protocol conforms to Quick Path Interconnect (QPI) protocols; or wherein the packetized, point-to-point protocol utilizes an embedded clock signal; or
   wherein the first gasket circuit and the second gasket circuit cause an optical link between them to operate at a data rate corresponding to the full data rate during initialization of links between the first electrical logic circuit and the second electrical logic circuit; or
   wherein the first electrical logic circuit comprises a processing core and the second electrical logic circuit comprises a memory.

3. The apparatus of claim 1 further comprising:

   a third gasket circuit coupled to receive the data from the second electrical logic circuit, the third gasket circuit to cause the data to be converted to the optical format to be transmitted at the rate that is at least double the full data rate;
   a fourth gasket circuit coupled to receive the data in the optical format from the third gasket circuit, the fourth gasket circuit to cause the data to be converted to an electrical format conforming to the packetized, point-to-point interconnect protocol and is coupled to provide the electrical data to the first electrical logic circuit.

4. The apparatus of claim 3 wherein the first gasket circuit and the third gasket circuit each multiplex M data lanes onto N lanes that interface to an electrical-to-optical conversion module to do electrical-to-optical conversion on the N lanes; optionally

wherein M is 20 and N is 10

5. The apparatus of claim 3 wherein the second gasket circuit and the fourth gasket circuit each receive N lanes of data from an optical-to-electrical conversion module to do optical-to-electrical conversion on the N lanes of data, the second gasket circuit and the fourth gasket circuit each to demultiplex the N lanes of data to M data lanes; or further comprising additional optical lanes to communicate sideband signals; optionally wherein the sideband signals are encoded.

6. The apparatus of claim 1 further comprising an optical signal state machine optionally wherein the optical state machine controls power states and power state transitions; or wherein the optical state machine controls optical training sequences.

7. The apparatus of claim 1, wherein the first gasket circuit and the second gasket circuit comprise retiming circuitry with at least one gasket phase locked loop (PLL) for a transmission clock; or further comprising a mechanism to assist a QuickPath Interconnect (QPI) compliant slow start operation; or further comprising one or more dynamic gain control circuits combined with digital front end (DFE) circuits to self-adapt to received signals, wherein periodic retraining for signal alignments are avoided.

8. An integrated circuit comprising:

   a first gasket circuit coupled to receive the data from a first electrical logic circuit, the first electrical logic circuit on a first die to communicate data according to a packetized, point-to-point interconnect protocol according to a full data rate, the first gasket circuit to cause the data to be converted to an optical format to be transmitted at a rate that is at least double the full data rate.

9. The integrated circuit of claim 8, the first gasket circuit coupled to cause optical data to be transmitted to a second gasket circuit, the a second gasket circuit coupled to receive the data in the optical format from the first gasket circuit, the second gasket circuit to cause the data to be converted to an electrical format conforming to the packetized, point-to-point interconnect protocol; or
   wherein the packetized, point-to-point interconnect protocol includes a snoop protocol; or
   wherein the packetized, point-to-point interconnect protocol manages cache coherence using a write-back protocol; or
   wherein the packetized, point-to-point interconnect protocol conforms to Quick Path Interconnect (QPI) protocols; or
   wherein the packetized, point-to-point protocol utilizes an embedded clock signal.

10. The integrated circuit of claim 8 wherein the first gasket circuit and the second gasket circuit cause an optical link between them to operate at a data rate corresponding to the full data rate during initialization of links between the first electrical logic circuit and the second electrical logic circuit; or
    wherein the first electrical logic circuit comprises a processing core and the second electrical logic circuit comprises a memory.

11. The integrated of claim 8 wherein the first gasket circuit multiplexes M data lanes onto N lanes that interface to an electrical-to-optical conversion module to do electrical-to-optical conversion on the N lanes; optionally
    wherein the second gasket circuit receives N lanes of data from an optical-to-electrical conversion module to do optical-to-electrical conversion on the N lanes of data, the second gasket circuit to demultiplex the N lanes of data to M data lanes; optionally
    wherein M is 20 and N is 10.

12. An integrated circuit comprising:

    a first gasket circuit coupled to receive the data an optical format from a second gasket circuit, the first gasket circuit to cause the data to be converted to an electrical format conforming to a packetized, point-to-point interconnect protocol; and
    a first electrical logic circuit on a first die coupled to receive the data from a remote first electrical logic circuit.

13. The integrated circuit of claim 12 further comprising the remote electrical logic circuit on a second die to communicate data according to the packetized, point-to-point interconnect protocol according to a full data rate; and
    the second gasket circuit coupled to receive the data from the first electrical logic circuit, the first gasket circuit to cause the data to be converted to an optical format to be transmitted at a rate that is at least double the full data rate.

14. The integrated circuit of claim 12 wherein the packetized, point-to-point interconnect protocol includes a snoop protocol; or
wherein the packetized, point-to-point interconnect protocol manages cache coherence using a write-back protocol; or
wherein the packetized, point-to-point interconnect protocol conforms to Quick Path Interconnect (QPI) protocols.

15. The integrated circuit of claim 12 wherein the first gasket circuit and the second gasket circuit cause an optical link between them to operate at a data rate corresponding to the full data rate during initialization of links between the first electrical logic circuit and the second electrical logic circuit; or
wherein the first electrical logic circuit comprises a memory; or
wherein the second electrical logic circuit comprises a processing core.

FIG. 1

| Phase:<br>State<br>O_Data:<br>O_Clk: | Optical Connect Phase<br>210 | | | Optical Training Phase<br>230 | | | | QPI Connect Phase<br>250 | | Optical Active<br>270 |
|---|---|---|---|---|---|---|---|---|---|---|
| | Disabled | OCLd<br><br>LSOP | OCL1<br><br>LSOP | OTR<br>PRBS9<br>O_FWD_CLK | OTP<br>PRBS9<br>O_FWD_CLK | OTP<br>invPRBS9<br>O_FWD_CLK | OTD<br>invPRBS9<br>O_FWD_CLK | QOU Crdt<br>invPRBS<br>O_FWD_CLK | QPI Drdy<br>invPRBS<br>O_FWD_CLK | OActive<br>QPI Data<br>O_FWD_CLK |

CLd_detect

CL1_detect

CLK_detect

O_CLK   LSOP CLd   LSOP CL1   O_FWD_CLK default operational speed   O_FWD_CLK speed

EP 2 778 939 A2

**FIG. 2**

# FIG. 2 (CONT.)

EP 2 778 939 A2

```
                    ┌──────────────────┐
                    │  Training Phase   │
                    │      OTP          │
                    └────────┬─────────┘
                             │
                    ┌────────▼─────────┐           305
                    │ Send Training Pattern │ ╲
                    └────────┬─────────┘
                             │
                          ╱──▼──╲         NO
                       ╱ CLK_detect ╲ ─────────►
                        ╲          ╱    310
                          ╲──┬──╱
                           Yes │
                          ╱──▼──╲          NO
                       ╱ Data_Lock? ╲ ─────────►
                        ╲          ╱    315
                          ╲──┬──╱
                           Yes │
                    ┌────────▼─────────┐          320
                    │ Send Pattern Inverted │ ╲
                    └────────┬─────────┘
                             │
                          ╱──▼──╲          NO
                       ╱ OT_sync? ╲ ─────────►
                        ╲        ╱     325
                          ╲──┬──╱
                             │
                          ╱──▼──╲        Yes
                       ╱ DIAG MODE? ╲ ──────────────┐
                        ╲          ╱                │
                    330   ╲──┬──╱                   │
                           NO │              ┌──────▼──────┐        335
                             │              │ SEND Start CMD │ ╲
                             │              │     Mode       │
                             │              └──────┬──────┘
                             │                     │
                             │              ┌──────▼──────┐        340
                             │         ┌───►│  RUN DIAG   │ ╲
                             │         │    └──────┬──────┘
                             │         │           │
                             │    Yes ╱──▼──╲  NO
                             │  ◄──── ╱Stop Cnt?╲──────┘
                             │         ╲       ╱
                             │      350  ╲──┬──╱  345
                    ┌────────▼─────────┐
                    │ Send SYNC:Done   │ ╲ 350
                    └────────┬─────────┘
                             │
                          ╱──▼──╲
                       ╱ OT_done? ╲
                        ╲        ╱
                    355   ╲──┬──╱
                    ┌────────▼─────────┐
                    │  Training Phase  │
                    │      OTD         │
                    └──────────────────┘
```

**FIG. 3**

**FIG. 4**

FIG. 5

500

Ref. Clk

**CORE 505** — Tx, data, clk, ctrl 8b, Rx, data, full data-rate
**Q2S 510** — Rx, Tx, retiming, ctrl 8b
**S2Q 570** — Tx, Rx, data, clk, retiming, full data-rate
**Drv 515** — data, clk
**SiP_0 520** — data, clk
**SiP_1 525** — data, clk
**TIA 530** — data, clk
**SiP_3 560** — data, clk
**TIA 565** — data, clk
**SiP_2 555** — data, clk
**Drv 550** — data, clk
2x data-rate
**S2Q 535** — Rx, Tx, data, clk, retiming
**Q2S 545** — Tx, Rx, ctrl 8b, data, clk, retiming, full data-rate
**CORE 540** — Rx, data, clk, Tx

DIGITAL
610

ANALOG
650

SCAN
615

CONTROL AND
STATUS REGISTERS
620

OPTICAL CTRL
LOGIC
(OCL)
625

Q2S
CTRL LOGIC
(QCL)
630

PLL
655

VRM
660

ANALOG
GEN
665

Q2S
AFE
(Q2SAFE)
670

Q2S MODULE
600

# FIG. 6

QPI
datarate

Half-rate
receive
clocking

Double-rate
data
transmission

Din<19:0> O⟶ ⟶ RxAFE **710**

Dbin<19:0> O⟶ ⟶

⟶ Sync
FIFO
**730**

⟶ TxAFE
**750** ⟶ TxData<9:0>

⟶ TxbData<9:0>

fwd_clk+   fwd_clk-

fwd_clk+   fwd_clk-   HTx_clk   HTx_clk-

FTx_clk+   FTx_clk-

# FIG. 7

Bias Current

D+ PAD

810

D- PAD

810

ESD PROT CIRCUITS 830

din

dbin

Q2S RxAFE 820

do<1:0>

dbo<1:0>

840 R_T

Activity detect 850

fwd_clk+

fwd_clk-

# FIG. 8

FIG. 9A

FIG. 9B

**FIG. 10**

EP 2 778 939 A2

EP 2 778 939 A2

odd    even    odd    even    odd    even    odd    even

Sampling ticks ➤

1UI 1UI 1UI 1UI 1UI 1UI 1UI

**FIG. 11**

**FIG. 12**

EP 2 778 939 A2

DIGITAL SIDE
1310

SCAN
1315

CONTROL AND
STATUS REGISTERS
1320

OPTICAL CTRL
LOGIC
(OCL)
1325

S2Q
CTRL LOGIC
(SCL)
1330

ANALOG SIDE
1350

PLL
1355

VRM
1360

ANALOG
GEN
1365

S2Q
AFE
(SAFE)
1370

S2Q MODULE
1300

# FIG. 13

| Rx | Tx |
|---|---|
| ??? 1405 | |
| DEX 1410 | Tcomp 1455 |
| CDR Ctrl 1415 | Rcomp 1460 |
| Clock ActiveID Detect (CAD) 1420 | Detect Ctrl 1465 |
| AGC 1425 | Tx Eq Ctrl 1470 |
| DFE Ctrl 1430 | Sync ctrl 1475 |
| SCL 1330 | RLL ctrl 1480 |

# FIG. 14

**FIG. 15**

**FIG. 16**

## FIG. 17A

```
din o——→  ┌──────┐         ┌──────────┐    4
           │  DB  │────────→│ Sampler  │──/──●────o do_<3:0>
dbin o———→ │ 1705 │────────→│  1710    │──/──●──o dbo_<3:0>
           └──────┘         └──────────┘  4  │  │
                                  ↑          │  │
                              ┌───────┐      │  │
                              │  DCC  │      │  │
                              └───────┘      │  │
                                  ↑      ┌────────┐
                            ┌──────────┐ │  CDR   │←─┘  │
                            │ PI  1720 │←│  1725  │←────┘
                            └──────────┘ └────────┘
                              0°    90°    ↑  ↑
                            ┌──────────┐   │  │
                            │   DLL    │───┘  │
                            │          │──────┘
                            └──────────┘
                              ↑    ↑
                           fwd_clk+  fwd_clk-
```

## FIG. 17B

```
        ┌──────────┐          ┌──────────┐
        │ AGC 1755 │          │ DFE Ctrl │
        └──────────┘          └──────────┘
              │                     │
              ↓                     ↓
din o——→  ┌──────┐         ┌──────────────┐    4
          │  DB  │────────→│ DFE/Sampler  │──/──●────o do_<3:0>
dbin o——→ │ 1750 │────────→│    1760      │──/──●──o dbo_<3:0>
          └──────┘         └──────────────┘  4  │  │
                                  ↑             │  │
                              ┌───────┐         │  │
                              │  DCC  │         │  │
                              └───────┘         │  │
                                  ↑        ┌────────┐
                            ┌──────────┐   │  CDR   │←─┘  │
                            │ PI  1775 │←──│  1770  │←────┘
                            └──────────┘   └────────┘
                              0°    90°      ↑  ↑
                            ┌──────────┐     │  │
                            │   DLL    │─────┘  │
                            │          │────────┘
                            └──────────┘
                              ↑    ↑
                           fwd_clk+  fwd_clk-
```

**FIG. 18**

Sampling ticks ➡

1UI 1UI 1UI 1UI 1UI 1UI 1UI

EP 2 778 939 A2

**FIG. 19**

EP 2 778 939 A2

**FIG. 20**

EP 2 778 939 A2

Fig. 21

41

EP 2 778 939 A2

A
B

| | | |
|---|---|---|
| Protocol Layer 2220a | Packets 2230 | Protocol Layer 2220b |
| Routing Layer 2215a | | Routing Layer 2215b |
| Link layer 2210a | Flits 2235 | Link Layer 2210b |
| Physical Layer 2205a | Phits 2240 | Physical Layer 2205b |

Fig. 22